(19) **Europäisches Patentamt / European Patent Office / Office européen des brevets**

(11) **EP 4 654 503 A1**

(12) **EUROPEAN PATENT APPLICATION**

(43) Date of publication:
26.11.2025 Bulletin 2025/48

(21) Application number: 25177909.6

(22) Date of filing: 21.05.2025

(51) International Patent Classification (IPC):
*H04L 1/00* (2006.01)  *H04L 5/00* (2006.01)

(52) Cooperative Patent Classification (CPC):
H04L 1/0057; H04L 1/0003; H04L 1/0009;
H04L 1/0017; H04L 1/007; H04L 5/0044;
H04L 5/006

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 24.05.2024 US 202463651710 P
08.10.2024 US 202418909877

(71) Applicant: Avago Technologies International
Sales
Pte. Limited
Singapore 768923 (SG)

(72) Inventors:
• Pulikkoonattu, Rethnakaran
Irvine, 92618 (US)
• Blanksby, Andrew
Irvine, 92618 (US)

(74) Representative: Dilg, Haeusler, Schindelmann
Patentanwaltsgesellschaft mbH
Leonrodstraße 58
80636 München (DE)

(54) **SYSTEMS AND METHODS FOR PROVIDING MULTIPLE CODE RATES ACROSS RESOURCE UNITS IN COMMUNICATION SYSTEMS**

(57) In some implementations, an apparatus may include a transmitter (120) and one or more processors (2010). The one or more processors (2010) may identify a plurality of resource units (RUs) (1022) used for transmitting respective data streams within one or more wireless channels. The one or more processors (2010) may determine, based at least on a difference in signal quality between transmissions across the plurality of RUs (1022), respective target code rates for the plurality of RUs (1022). The respective target code rates may be different from each other and different from a base code rate of a low density parity check (LDPC) code. The one or more processors (2010) may encode, by an LDPC encoder (1006) using the LDPC code with the base code rate, the respective data streams to generate respective encoded data streams at the respective target code rates. The transmitter (120) may transmit the respective encoded data streams using the plurality of respective RUs (1022).

100

FIG. 1

EP 4 654 503 A1

**Description**

**Cross-Reference to Related Applications**

This application claims the benefit of and priority to U.S. Provisional Patent Application No. 63/651,710 filed on May 24, 2024, which is incorporated herein by reference in its entirety for all purposes.

**Field of the Disclosure**

This disclosure generally relates to systems and methods for improving encoding/decoding process of a communications system, including but not limited to systems and methods of providing multiple code rates over resource units (RUs) in communication systems for interference mitigation.

**Background**

Error correcting codes enable information data to be exchanged between a transmitter communication system and a receiver communication system in a reliable manner. A transmitter communication system encodes the information data to obtain a codeword. The codeword is encoded information data. The transmitter communication system transmits the codeword to the receiver communication system. Due to noise in the communication channel, the transmission received by the receiver communication system may not be identical to the transmitted codeword. Encoding information data allows a receiver communication system with a proper decoding process to recover the information data from the received transmission despite such noise. For example, the transmitter communication system transmits parity bits to the receiver communication system. The parity bits allow the receiver communication system to verify whether the received transmission is a valid codeword and to correct errors in the transmission if the received transmission is not a valid codeword. In one approach, generating parity bits involves a complex process.

**Brief Description of the Drawings**

Various objects, aspects, features, and advantages of the disclosure will become more apparent and better understood by referring to the detailed description taken in conjunction with the accompanying drawings, in which like reference characters identify corresponding elements throughout. In the drawings, like reference numbers generally indicate identical, functionally similar, and/or structurally similar elements.

FIG. 1 is a diagram depicting an example communication environment with communication systems, according to one or more embodiments.
FIG. 2 is a schematic block diagram of a computing system, according to one or more embodiments.
FIG. 3 is a diagram depicting an example exponent matrix, according to one or more embodiments.
FIG. 4 is a diagram depicting example shifted identity matrices for generating a parity check matrix, according to one or more embodiments.
FIG. 5 is a diagram depicting an example parity check matrix, according to one or more embodiments.
FIG. 6 is a diagram depicting an example exponent matrix, according to one or more embodiments.
FIG. 7 is a diagram depicting a structure of a packet, according to one or more implementations.
FIG. 8 is a diagram depicting an allocation structure of resource units (RUs) in a bandwidth of 20 MHz, according to one or more implementations.
FIG. 9 is a diagram depicting different modulation and coding configurations across different RUs, according to one or more embodiments.
FIG. 10 is a diagram depicting an example encoding and modulation system across RUs, according to one or more embodiments.
FIG. 11A and FIG. 11B are diagrams depicting example parameters with different multi-rate LDPC codes according to one or more embodiments.
FIG. 12A and FIG. 12B are block diagrams depicting example input and output parameters for a multi-rate LDPC code according to one or more embodiments.
FIG. 13A to FIG. 13C are diagrams depicting example processes of splitting data by a medium access control (MAC) layer or a physical (PHY) layer, according to one or more embodiments.
FIG. 14 is a diagram depicting an example process of encoding data with two code rates using a single LDPC encoder, according to one or more embodiments.
FIG. 15 is a diagram depicting an example process of encoding data with two code rates based on different code block lengths using different LDPC encoders, according to one or more embodiments.

FIG. 16 is a diagram depicting another example process of encoding data with two code rates based on different code block lengths using different LDPC encoders, according to one or more embodiments.

FIG. 17 is a flow diagram showing a process for providing multiple code rates across RUs, in accordance with an embodiment.

The details of various embodiments of the methods and systems are set forth in the accompanying drawings and the description below.

<u>**Detailed Description**</u>

The following disclosure provides many different embodiments, or examples, for implementing different features of the provided subject matter. Specific examples of components and arrangements are described below to simplify the present disclosure. These are, of course, merely examples and are not intended to be limiting. For example, a first feature in communication with or communicatively coupled to a second feature in the description that follows may include embodiments in which the first feature is in direct communication with or directly coupled to the second feature and may also include embodiments in which additional features may intervene between the first and second features, such that the first feature is in indirect communication with or indirectly coupled to the second feature. In addition, the present disclosure may repeat reference numerals and/or letters in the various examples. This repetition is for the purpose of simplicity and clarity and does not in itself dictate a relationship between the various embodiments and/or configurations discussed.

Although various embodiments disclosed herein are described for encoding and/or decoding data for a wireless communication (e.g., wireless local area network (WLAN) conforming to any IEEE 802.11 standard including IEEE 802.11bn), principles disclosed herein are applicable to other types of communication (e.g., wired communication) or any process that performs encoding for error correction codes (e.g., low-density parity check (LDPC) codes, forward error correction (FEC) codes).

I. LDPC-Based Encoding/Decoding Systems

Generally, a parity check matrix for a code represents equations that determine whether errors have occurred during transmission. More formally, for all valid codewords (i.e., bits produced by the encoder with no errors), the following equation can be true:

$$\mathbf{Hc=0} \ \dots\dots\dots\dots \ (\text{Equation } 1)$$

In Equation 1, "H" is the parity check matrix, **"c"** is a codeword vector, and **"0"** is a vector of all zeroes. The parity check matrix, **H,** is one way of describing a code.

A generator matrix for a code, **G,** satisfies the following equation:

$$\mathbf{sG=c} \ \dots\dots\dots\dots \ (\text{Equation } 2)$$

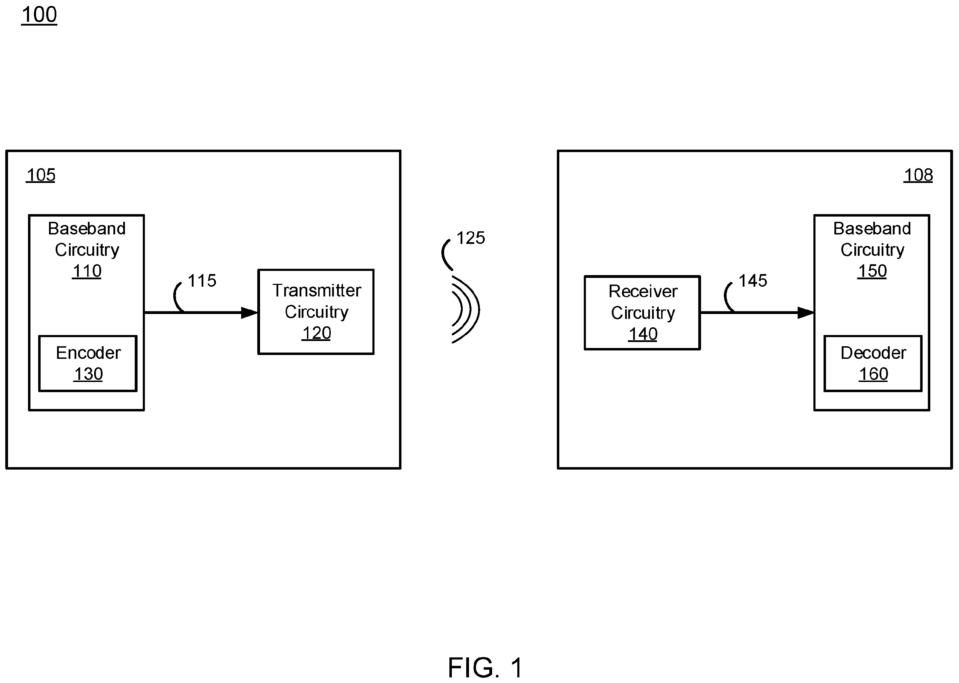

In Equation 2, "s" is a vector of information bits, **"G"** is a generator matrix and **"c"** is the codeword that corresponds to **"s."** In some implementations, a system (e.g., a communication system 108 including a decoder 160 in FIG. 1) can decode the codeword c to obtain the decoded data s using Equation 2.

The parity check and generator matrices for a code are related per the above matrix equations. Generally, if a parity check matrix is low density, the corresponding generator matrix will be high density, and vice versa. LDPC codes are accordingly characterized by low density parity check matrices and high density generator matrices. The density of a matrix relates to the number of operations that must be performed to implement one of the above equations. Although it was recognized by 1995 that LDPC codes could be used to transmit data with very few errors, i.e., with error rates as good or better than turbo codes, one disadvantage of LDPC codes is that their generator matrices were high density and that made encoding computationally intensive, rending the codes impractical for many applications.

In some implementations, a parity check matrix may have a quasi-cyclic structure, for example, a parity check matrix for QC-LDPC code (n=3888, k=2916, R=3/4). Given a lifting size z, the parity check matrix may have a plurality of sub-matrices such that each submatrix is cyclically shifted version of an identity matrix of size (z x z), where z=162, for example. In some implementations, the lifting can be performed in a hierarchical way, where in lifting by 162/W followed by lifting W, where W is a whole number, to realize an overall lifting of 162. A parity check matrix can be represented in two equivalent forms: (1) parity check matrix H and (2) a block matrix or an exponent matrix P=E(H).

In some implementations, a parity check matrix H may be a binary matrix whose size is m x n (each of m and n is an integer). Elements of the parity check matrix are binary values. Given a block length n and a code rate R, an LDPC code (or QC-LDPC code) LDPC (n, R) satisfies the following equations:

$$k = nR \quad \dots\dots\dots\dots \text{(Equation 3)}$$

$$m = n(1\text{-}R) \quad \dots\dots\dots\dots \text{(Equation 4)}$$

In some implementations, a block matrix or an exponent matrix (QC-LDPC exponent matrix) may be obtained. Given a lifting size z, the exponent matrix P=E(H) may have a size of m/z x n/z. If n=24z (e.g., n=3888, z=162), then the size of P=E(H) is 24(1-R) x 24 (= n(1-R)/z x n/z). Elements of the exponent matrix may be integer values which correspond to cyclic shift values of identity matrix of size z x z. A parity check matrix H may be a sparse binary matrix that can be derived from an exponent matrix P=E(H). The generator matrix G may have a size n x k in binary form (e.g., elements of the generator matrix G are binary values). The exponent matrix P=E(H) may have a structure including a plurality of sub-matrices (e.g., A, B, C, D, E, T).

In some implementations, a binary QC-LDPC code LDPC (n, R) may be characterized by the null space of an n(1-R)×n parity check matrix H. The parity check matrix H may be a binary sparse matrix which includes a set of circulant matrices of size z x z. The parity-check matrix H of a QC-LDPC code can be represented equivalently by an exponent matrix P=E(H). This representation can help to illustrate the graphical structure of the underlying code as a base graph along with coefficient of shifting.

In some implementations, a parity check matrix H may be generated from an exponent matrix P=E(H). The exponent matrix P=E(H) may include (as elements) shift values d in the range 0<=d<z along with d=-1. For example, if z=7, the shift values d may include -1, 0, 1, 2, 3, 4, 5, 6. The shift value d=0 may correspond (or map) to an identity matrix of size z x z, denoted by I(z). The shift value d=-1 may correspond (or map) to a null matrix (all elements zero) of size z x z, denoted by 0*I(z). Any other integer value d in [1,z-1] may correspond (or map) to a matrix cyclically right shifted from I(z). The parity check matrix H can be obtained from the exponent matrix P=E(H) by expanding the exponent matrix P such that each element of the exponent matrix P (as a shift value d) is replaced by a matrix corresponding to the shift value.

In some implementations, the exponent matrix P=E(H) may include a plurality of elements P1,1, P1,2, P1,3, ..., P1,ń; P2,1, P2,2, P2,3, ..., P2,ń; ..., P1,1, P1,2, P1,3, ..., Pḿ,ń, which correspond to (m x ń) values where ḿ and ń satisfy the following equations:

$$\acute{m} = n(1\text{-}R)/z \quad \dots\dots\dots\dots \text{(Equation 5)}$$

$$\acute{n} = n/z \quad \dots\dots\dots\dots \text{(Equation 6)}$$

The exponent matrix (or permutation matrix) P=E(H) may be expressed as following:

$$P \equiv E(H) = \begin{pmatrix} P_{1,1} & P_{1,2} & P_{1,3} & \cdots & \cdots & P_{1,\acute{n}} \\ P_{2,1} & P_{2,2} & P_{2,3} & \cdots & \cdots & P_{2,\acute{n}} \\ \cdots & \ddots & \ddots & \cdots & \cdots & \vdots \\ P_{\acute{m},1} & P_{\acute{m},2} & P_{\acute{m},3} & \cdots & \cdots & P_{\acute{m},\acute{n}} \end{pmatrix}$$

$$\dots\dots\dots\dots$$

(Equation 7)

The corresponding parity check matrix H may be obtained by replacing each element of the matrix (as a shift value d) by a matrix C(d) corresponding to the shift value as follows:

$$H = \begin{pmatrix} C(P_{1,1}) & C(P_{1,2}) & C(P_{1,3}) & \dots & \dots & C(P_{1,\acute{n}}) \\ C(P_{2,1}) & C(P_{2,2}) & C(P_{2,3}) & \dots & \dots & C(P_{2,\acute{n}}) \\ \dots & \ddots & \ddots & \dots & \dots & \vdots \\ C(P_{\acute{m},1}) & C(P_{\acute{m},2}) & C(P_{\acute{m},3}) & \dots & \dots & C(P_{\acute{m},\acute{n}}) \end{pmatrix} \dots\dots\dots \text{(Equation 8)}$$

For example, a matrix C(1) may be expressed as follows:

$$C(1) = \begin{pmatrix} 0 & 1 & 0 & \dots & \dots & 0 \\ 0 & 0 & 1 & \dots & \dots & \ddots \\ \ddots & \ddots & \ddots & \dots & \dots & \vdots \\ 0 & 0 & 0 & \dots & \dots & 1 \\ 1 & 0 & 0 & \dots & \dots & 0 \end{pmatrix} \dots\dots\dots \text{(Equation 9)}$$

In some implementations, an encoder can produce codewords using a generator matrix (e.g., using Equation 2). In some implementations, an encoder can use the parity check matrix (rather than the generator matrix) to produce codewords from vectors of information bits. After a parity check matrix H is obtained, the parity check matrix H may have sub-matrices A, B, C, D, T, E. An upper area O of the sub-matrix T may correspond to an area in which the matrix contains all zeroes, and the other areas may represent locations that can contain ones.

In some implementations, the codeword c can be obtained by the following expression:

$$c = [s\ p1\ p2] \dots\dots\dots \text{(Equation 10)},$$

where "s" is the vector of information bits to be encoded, "pi" is a vector of the first g parity bits and "$p_2$" is a vector of the remaining m-g parity bits.

The vectors p1 and p2 can be obtained by the following equations:

$$\Phi = -ET^{-1}B + D \dots\dots\dots \text{(Equation 11)};$$

$$p_1^T = -\Phi^{-1}(-ET^{-1}A + C)\ s^T \dots\dots\dots \text{(Equation 12)};$$

and

$$p_2^T = -T^{-1}(As^T + Bp_1^T) \dots\dots\dots \text{(Equation 13)}.$$

Although various embodiments disclosed herein are described for encoding data for a wireless communication (e.g., wireless local area network (WLAN) conforming to any IEEE 802.11 standard), principles disclosed herein are applicable to other types of communication (e.g., wired communication) or any process that performs encoding for LDPC codes.

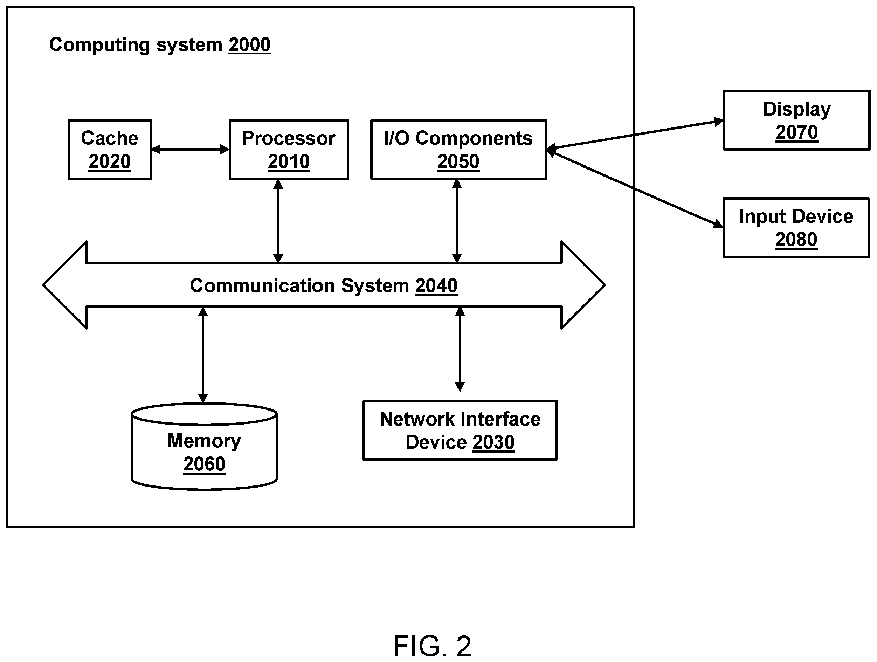

Referring to FIG. 1, illustrated is a diagram depicting an example communication environment 100 including communication systems (or communication apparatuses) 105, 108, according to one or more embodiments. In one embodiment, the communication system 105 includes a baseband circuitry 110 and a transmitter circuitry 120, and the communication system 108 includes a baseband circuitry 150 and a receiver circuitry 140. In one aspect, the communication system 105 is considered a transmitter communication system, and the communication system 108 is considered a receiver communication system. These components operate together to exchange data (e.g., messages or frames) through a wireless medium. These components are embodied as application specific integrated circuit (ASIC), field programmable gate array (FPGA), or any combination of these, in one or more embodiments. In some implementations, the communication systems 105, 108 include more, fewer, or different components than shown in FIG. 1. For example, each of the communication systems 105, 108 includes transceiver circuitry to allow bi-directional communication between the communication systems 105, 108 or with other communication systems. In some implementations, each of the communication systems 105, 108 may have configuration similar to that of a computing system 2000 as shown in FIG. 2.

The baseband circuitry 110 of the communication system 105 is a circuitry that generates the baseband data 115 for transmission. The baseband data 115 includes information data (e.g., signal(s)) at a baseband frequency for transmission. In one approach, the baseband circuitry 110 includes an encoder 130 that encodes the data and generates or outputs parity bits. In one aspect, the baseband circuitry 110 (or encoder 130) obtains a generator matrix or a parity check matrix or uses a previously produced generator matrix or a previously produced parity check matrix and encodes the information data by applying the information data to the generator matrix or the parity check matrix to obtain a codeword. In some implementations, the baseband circuitry 110 stores one or more generator matrices or one or more parity check matrices that conform to any IEEE 802.11 standard for WLAN communication. The baseband circuitry 110 retrieves the stored generator matrix or the stored parity check matrix in response to detecting information data to be transmitted, or in response to receiving an instruction to encode the information data. In one approach, the baseband circuitry 110 generates the parity bits according to a portion of the generator matrix or using the parity check matrix and appends the parity bits to the information bits to form a codeword. The baseband circuitry 110 generates the baseband data 115 including the codeword for the communication system 108 and provides the baseband data 115 to the transmitter circuitry 120.

The transmitter circuitry 120, generally referred to as transmitter(s), of the communication system 105 includes or corresponds to a circuitry that receives the baseband data 115 from the baseband circuitry 110 and transmits a wireless signal 125 according to the baseband data 115. In one configuration, the transmitter circuitry 120 is coupled between the baseband circuitry 110 and an antenna (not shown). In this configuration, the transmitter circuitry 120 up-converts the baseband data 115 from the baseband circuitry 110 onto a carrier signal to generate the wireless signal 125 at a radio frequency (RF) frequency (e.g., 10 MHz to 60 GHz), and transmits the wireless signal 125 through the antenna.

The receiver circuitry 140 of the communication system 108 is a circuitry that receives the wireless signal 125 from the communication system 105 and obtains baseband data 145 from the received wireless signal 125. In one configuration, the receiver circuitry 140 is coupled between the baseband circuitry 150 and an antenna (not shown). In this configuration, the receiver circuitry 140 receives the wireless signal 125 though the antenna, and down-converts the wireless signal 125 at an RF frequency according to a carrier signal to obtain the baseband data 145 from the wireless signal 125. The receiver circuitry 140 then provides the baseband data 145 to the baseband circuitry 150.

The baseband circuitry 150 of the communication system 108 includes or corresponds to a circuitry that receives the baseband data 145 from the receiver circuitry 140 and obtains information data from the received baseband data 145. In one embodiment, the baseband circuitry 150 includes a decoder 160 that extracts information and parity bits from the baseband data 145. The decoder 160 decodes the baseband data 145 to obtain the information data generated by the baseband circuitry 110 of the communication system 105.

In some implementations, each of the baseband circuitry 110 (including the encoder 130), the transmitter circuitry 120, the receiver circuitry 140, and the baseband circuitry 150 (including the decoder 160) may be as one or more processors, application specific integrated circuit (ASIC), field programmable gate array (FPGA), or any combination of them.

FIG. 2 is a schematic block diagram of a computing system, according to an embodiment. An illustrated example computing system 2000 includes one or more processors 2010 in direct or indirect communication, via a communication system 2040 (e.g., bus), with memory 2060, at least one network interface controller 2030 with network interface port for connection to a network (not shown), and other components, e.g., input/output ("I/O") components 2050. Generally, the processor(s) 2010 will execute instructions (or computer programs) received from memory. The processor(s) 2010 illustrated incorporate, or are connected to, cache memory 2020. In some instances, instructions are read from memory 2060 into cache memory 2020 and executed by the processor(s) 2010 from cache memory 2020. The computing system 2000 may not necessarily contain all of these components shown in FIG. 2 and may contain other components that are not shown in FIG. 2.

In more detail, the processor(s) 2010 may be any logic circuitry that processes instructions, e.g., instructions fetched from the memory 2060 or cache 2020. In many implementations, the processor(s) 2010 are microprocessor units or special purpose processors. The computing device 2050 may be based on any processor, or set of processors, capable of operating as described herein. The processor(s) 2010 may be single core or multi-core processor(s). The processor(s) 2010 may be multiple distinct processors.

The memory 2060 may be any device suitable for storing computer readable data. The memory 2060 may be a device with fixed storage or a device for reading removable storage media. Examples include all forms of volatile memory (e.g., RAM), non-volatile memory, media and memory devices, semiconductor memory devices (e.g., EPROM, EEPROM, SDRAM, and flash memory devices), magnetic disks, magneto optical disks, and optical discs (e.g., CD ROM, DVD-ROM, or Blu-Ray® discs). A computing system 2000 may have any number of memory devices 2060.

The cache memory 2020 is generally a form of computer memory placed in close proximity to the processor(s) 2010 for fast read times. In some implementations, the cache memory 2020 is part of, or on the same chip as, the processor(s) 2010. In some implementations, there are multiple levels of cache 2020, e.g., L2 and L3 cache layers.

The network interface controller 2030 manages data exchanges via the network interface (sometimes referred to as network interface ports). The network interface controller 2030 handles the physical and data link layers of the OSI model for network communication. In some implementations, some of the network interface controller's tasks are handled by one or more of the processor(s) 2010. In some implementations, the network interface controller 2030 is part of a processor 2010. In some implementations, the computing system 2000 has multiple network interfaces controlled by a single controller 2030. In some implementations, the computing system 2000 has multiple network interface controllers 2030. In some implementations, each network interface is a connection point for a physical network link (e.g., a cat-5 Ethernet link). In some implementations, the network interface controller 2030 supports wireless network connections and an interface port is a wireless (e.g., radio) receiver or transmitter (e.g., for any of the IEEE 802.11 protocols, near field communication "NFC", Bluetooth, ANT, or any other wireless protocol). In some implementations, the network interface controller 2030 implements one or more network protocols such as Ethernet. Generally, a computing device 2050 exchanges data with other computing devices via physical or wireless links through a network interface. The network interface may link directly to another device or to another device via an intermediary device, e.g., a network device such as a hub, a bridge, a switch, or a router, connecting the computing device 2000 to a data network such as the Internet.

The computing system 2000 may include, or provide interfaces for, one or more input or output ("I/O") devices. Input devices include, without limitation, keyboards, microphones, touch screens, foot pedals, sensors, MIDI devices, and pointing devices such as a mouse or trackball. Output devices include, without limitation, video displays, speakers, refreshable Braille terminal, lights, MIDI devices, and 2-D or 3-D printers.

Other components may include an I/O interface, external serial device ports, and any additional co-processors. For example, a computing system 2000 may include an interface (e.g., a universal serial bus (USB) interface) for connecting input devices, output devices, or additional memory devices (e.g., portable flash drive or external media drive). In some implementations, a computing device 2000 includes an additional device such as a co-processor, e.g., a math co-processor can assist the processor 2010 with high precision or complex calculations.

The components 2090 may be configured to connect with external media, a display 2070, an input device 2080 or any other components in the computing system 2000, or combinations thereof. The display 2070 may be a liquid crystal display (LCD), an organic light emitting diode (OLED) display, a flat panel display, a solid state display, a cathode ray tube (CRT) display, a projector, a printer or other now known or later developed display device for outputting determined information. The display 2070 may act as an interface for the user to see the functioning of the processor(s) 2010, or specifically as an interface with the software stored in the memory 2060.

The input device 2080 may be configured to allow a user to interact with any of the components of the computing system 2000. The input device 2080 may be a plurality pad, a keyboard, a cursor control device, such as a mouse, or a joystick. Also, the input device 2080 may be a remote control, touchscreen display (which may be a combination of the display 2070 and the input device 2080), or any other device operative to interact with the computing system 2000, such as any device operative to act as an interface between a user and the computing system 2000.

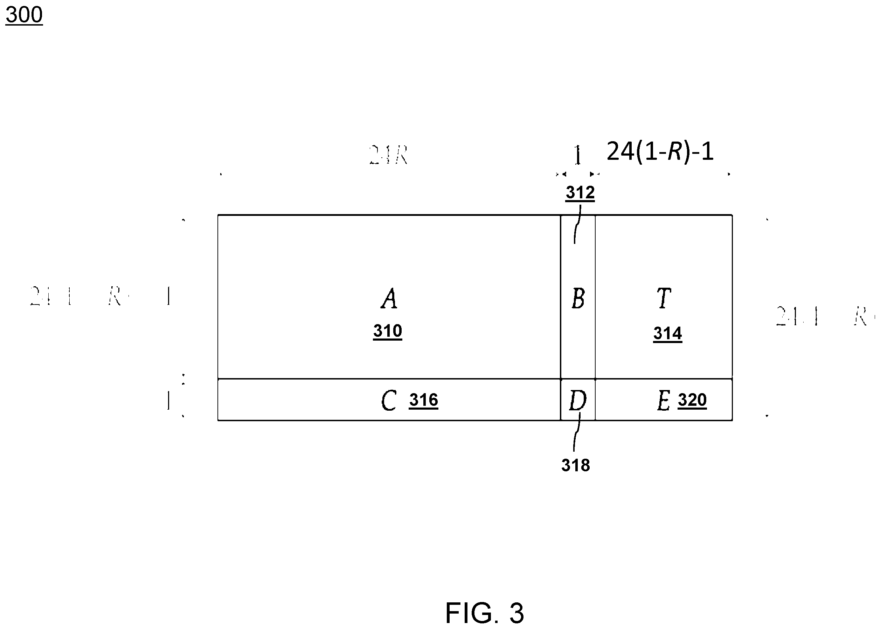

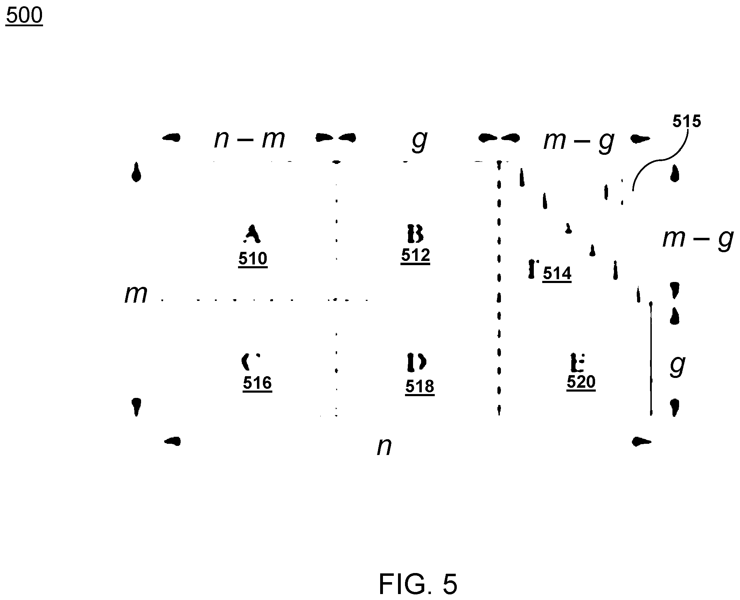

FIG. 3 is a diagram depicting an example exponent matrix (QC-LDPC exponent matrix) 300, according to one or more embodiments. Given a lifting size z, the exponent matrix 300 may have a size of m/z x n/z. If n=24z (e.g., n=3888, z=162), then the size of P=E(H) is 24(1-R) x 24 (= n(1-R)/z x n/z). Elements of the exponent matrix may be integer values which correspond to cyclic shift values of identity matrix of size z x z. A parity check matrix H (see FIG. 5) may be a sparse binary matrix that can be derived from an exponent matrix P=E(H). The generator matrix G may have a size n x k in binary form (e.g., elements of the generator matrix G are binary values). Referring to FIG. 3, the exponent matrix P=E(H) may have a structure including a plurality of sub-matrices (e.g., A 310, B 312, C 316, D 318, E 320, T 314).

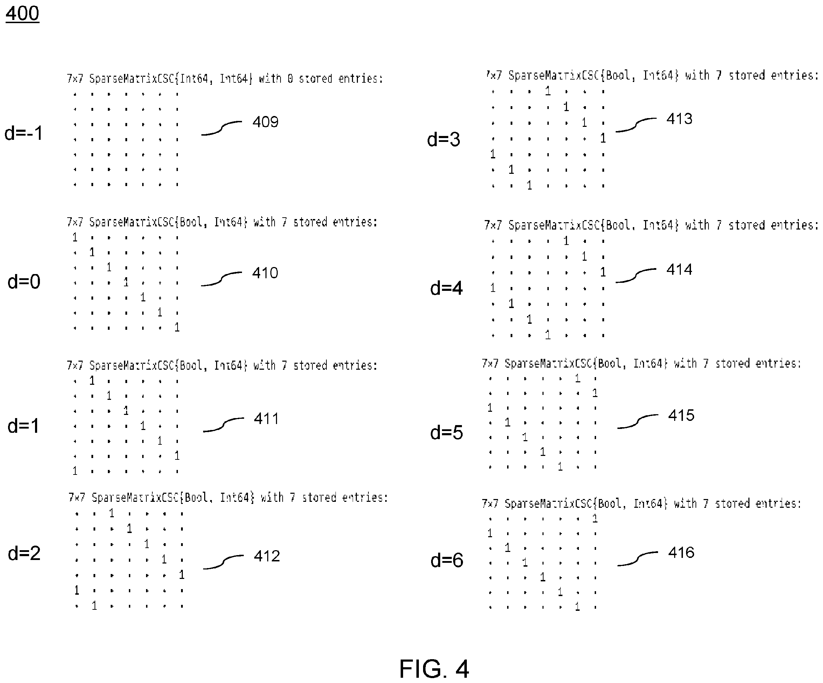

FIG. 4 is a diagram 400 depicting example shifted identity matrices 409, 410, 411, 412, 413, 414, 415, 416 for generating a parity check matrix, according to one or more embodiments. A parity check matrix H may be generated from an exponent matrix P=E(H) (e.g., exponent matrix 300) or may be identified using a codebook. As shown in Equation 7, the exponent matrix P=E(H) may include (as elements) shift values d in the range 0<=d<z along with d=-1. See Equation For example, if z=7, the shift values d may include -1, 0, 1, 2, 3, 4, 5, 6 (see FIG. 4). The shift value d=0 may correspond (or map) to an identity matrix of size z x z, denoted by I(z) (e.g., matrix 410). The shift value d=-1 may correspond (or map) to a null matrix (all elements zero) of size z x z, denoted by 0*I(z) (e.g., matrix 409). Any other integer value d in [1,z-1] may correspond (or map) to a matrix cyclically right shifted from I(z) (e.g., matrices 411, 412, 413, 414, 415, 416). As shown in Equation 8, the parity check matrix H can be obtained from the exponent matrix P=E(H) by expanding the exponent matrix P such that each element of the exponent matrix P (as a shift value d) is replaced by a matrix corresponding to the shift value.

FIG. 5 is a diagram depicting an example parity check matrix 500, according to one or more embodiments. In some implementations, an encoder (e.g., encoder 130) can produce codewords using a generator matrix (e.g., using Equation 2). In some implementations, an encoder (e.g., encoder 130) can use the parity check matrix (rather than the generator matrix) to produce codewords from vectors of information bits. After a parity check matrix H is obtained (e.g., using a codebook), the parity check matrix H (e.g., parity check matrix 500) may have sub-matrices A 510, B 512, C 516, D 518, T 514, E 520. An upper area O 515 of the sub-matrix T 514 (e.g., white area in FIG. 5) may correspond to an area in which the matrix contains all zeroes, and the other areas (e.g., grey area in FIG. 5) may represent locations that can contain ones. The size of the parity check matrix 500 may be m x n where the size of the sub-matrix D 518 is g x g, and the size of the sub-matrix T is (m-g)x(m-g). In some implementations, given a vector s of information bits to be encoded, the encoder can obtain a codeword c using Equation 10, Equation 11, Equation 12 and Equation 13.

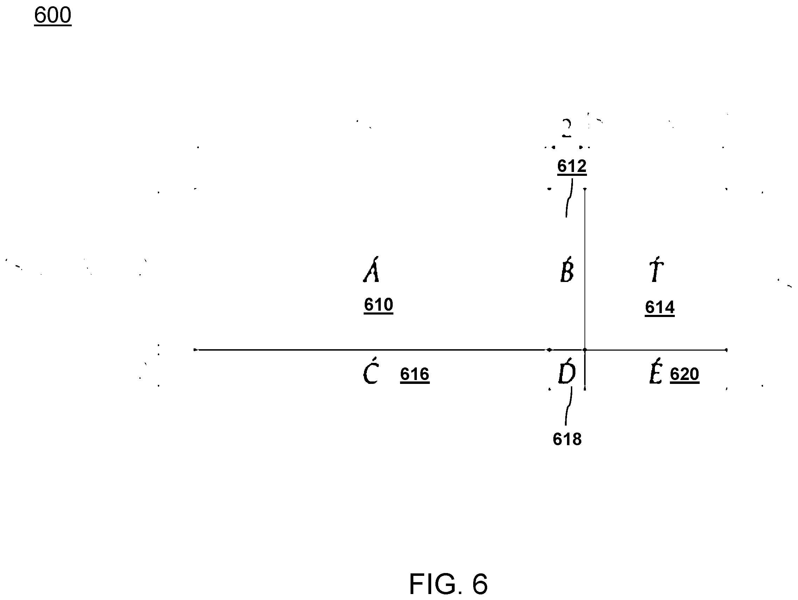

FIG. 6 is a diagram depicting an example exponent matrix (QC-LDPC exponent matrix) 600, according to one or more embodiments. Given a lifting size z, the exponent matrix 600 may have a size of m/z x n/z. If n=48z (e.g., n=3888, z=81), then the size of P=E(H) matrix for n=3888 is 48(1-R) x 48 (= n(1-R)/z x n/z). Elements of the exponent matrix may be integer values which correspond to cyclic shift values of identity matrix of size z x z. A parity check matrix H may be a sparse binary matrix that can be derived from an exponent matrix P=E(H). The generator matrix G may have a size n x k in binary form (e.g., elements of the generator matrix G are binary values). Referring to FIG. 6, the exponent matrix P=E(H) may have a structure including a plurality of sub-matrices (e.g., Á 310, Ḃ 312, Ć 316, Ḋ 318, É 320, Ṫ 314).

II. Resource Units in a Communication System

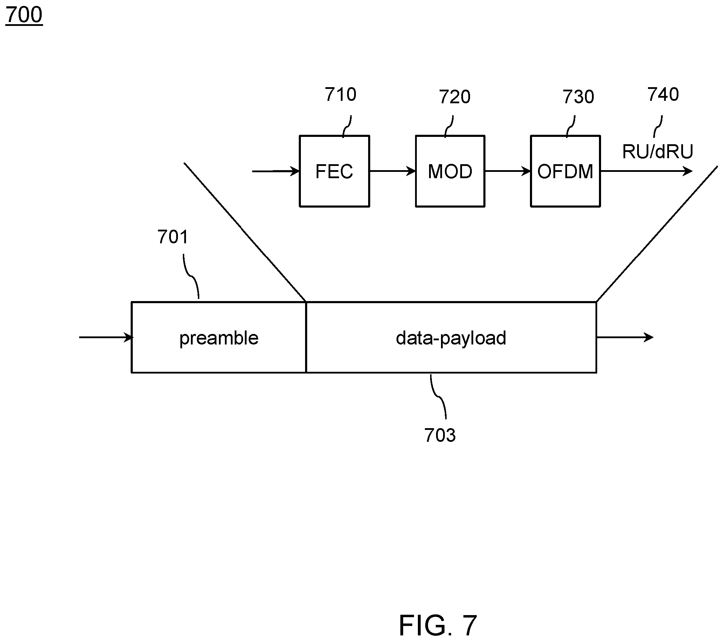

FIG. 7 is a diagram depicting a structure or format of a packet 700 (e.g., an enhanced long range (ELR) packet), according to one or more implementations. The packet 700 may be a physical layer protocol data unit (PPDU) including a preamble 701, and a data payload 703. The preamble may include a legacy preamble which may be a WLAN-compatible (e.g., IEEE 802.11be-compatible) preamble. The preamble may include an ELR preamble which may be used for detection of ERL packets (e.g., by containing a particular sequence of bit values). The data payload may be encoded using a forward error correction (FEC) scheme 710, modulated using a digital modulation scheme 720 and a channel modulation scheme such as orthogonal frequency division multiplexing access (OFDMA) 730. In some implementations, the FEC scheme may be implemented using LDPC codes. Resource units (RUs) or distributed resource units (dRUs) can be defined, allocated, designed and/or configured for an OFDMA channel. A resource unit refers to a group of subcarriers or tones within a OFDMA channel, or any frequency bandwidth unit within a frequency bandwidth of a communication channel or a communication system, The data payload may be transmitted using the defined/allocated/designed/configured RUs or dRUs 740.

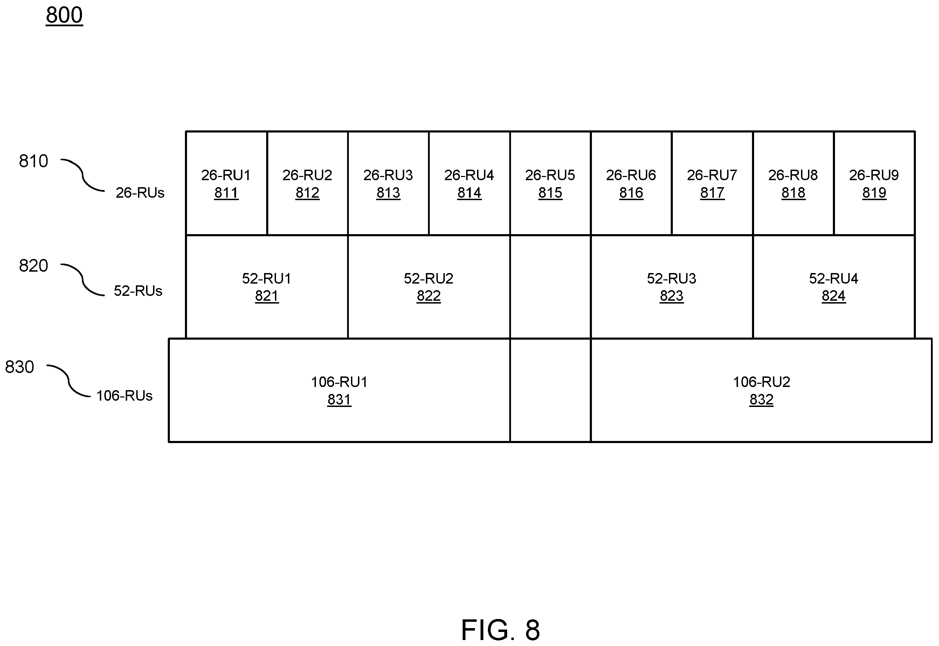

FIG. 8 is a diagram depicting an allocation structure 800 of resource units (RUs) in a bandwidth of 20 MHz, according to one or more implementations. A 20 MHz channel can be divided into multiple RUs, each including a number of subcarriers (or tones). For example, 256 tones of the 20 MHz chancel can be allocated/grouped into (1) RUs including 26 tones (referred to as "26-RUs" 810), (2) RUs including 52 tones (referred to as "52-RUs" 820), or (3) RUs including 106 tones (referred to as "106-RUs" 830). As shown in FIG. 8, the 26-RUs 810 may include nine 26-RUs including 26-RU1 811, 26-RU2 812, 26-RU3 813, 26-RU4 814, 26-RU5 815, 26-RU6 816, 26-RU7 817, 26-RU8 818, and 26-RU9 819. The 52-RUs 820 may include four 52-RUs including 52-RU1 821, 52-RU2 822, 52-RU3 823, and 52-RU4 824 such that (1) 52-RU1 821 includes tones allocated to 26-RU1 811 and 26-RU2 812; (2) 52-RU2 822 includes tones allocated to 26-RU3 813 and 26-RU4 814; (3) 52-RU3 823 includes tones allocated to 26-RU6 816 and 26-RU7 817; and (4) 52-RU4 824 includes tones allocated to 26-RU8 818 and 26-RU9 819. The 106-RUs 830 may include two 106-RUs including 106-RU1 831 and 106-RU2 832 such that (1) 106-RU1 831 includes tones allocated to 26-RU1 811 through 26-RU4 814; and (2) 106-RU2 832 includes tones allocated to 26-RU6 816 through 26-RU9 819.

III. Multiple Code Rates Across Resource Units

In one aspect, there may be a difference or a gap in signal quality between frequency bandwidth chunks or RUs (see FIG. 8). The difference in the signal quality may be caused by the presence of noise, other wireless device (e.g., overlapping basic service sets (OBSS)), other wireless signals (e.g., signal jamming due to a jammer), or other interference (e.g., electromagnetic interference (EMI), inter-carrier interference (ICI), etc.). The signal quality refers to a signal-to-noise (SNR), an error vector magnitude (EVM), other signal strength measures (e.g., received signal strength indicator (RSSI), reference signal received quality (RSRQ), reference signal received power (RSRP), signal-to-interference-plus-noise ratio (SINR), etc.), or any quality relating to the strength, clarity or reliability of electronic signals. In the presence of such unequal conditions in different RUs, a fixed FEC scheme (e.g., an LDPC code with a fixed code rate) for a plurality of streams may not effectively use the RUs. For example, if there are a strongest RU (e.g., RU having a highest signal quality) and a weakest RU (e.g., RU having a lowest signal quality), the same fixed code rate may be too low to be used to transmit the encoded data using the strongest RU, or may be too high to be used to transmit the encoded data using the weakest RU.

In one aspect, LDPC codes can have certain code rates that can be used as target code rates for multiple designs/implementations in communication standards (e.g., IEEE 802.11bn UHR chips). An LDPC encoder may take a block of k bits of information bits (e.g., k=1458) and produce n coded bits with the code rate R=k/n (e.g., R=3/4, n=1944). The LDPC codes refer to systematic LDPC codes, quasi-cyclic (QC) LDPC codes or any error correction code using a parity check matrix which is defined as a set of equations that are satisfied by any valid code word. The code rate R of an LDPC code refers to a ratio of the number of information bits (denoted by k) to the code block size (denoted by n). An LDPC decoder may operate on (noisy version of ) n received bits and (ideally) recover the k information bits. However, a conventional LDPC code may have a fixed code rate R for a fixed size of information bits k, and LDPC codes with different code rates may not be easily constructed (or generated, configured, designed, implemented).

To solve this problem, systems and methods according to some embodiments of the present disclosure can perform different modulation and coding schemes (MCSs) across different resource units (RU), or different bandwidth segments (e.g., a primary bandwidth and a secondary bandwidth in wireless LANs or cellular communications) to mitigate interferences caused by the presence of noise, other wireless device (e.g., OBSS), other wireless signals (e.g., signal jamming due to a jammer), or other interference (e.g., EMI, ICI, etc.). In some implementations, a communication system can perform unequal modulation and coding methods across different frequency segments (e.g., different RUs) without having to use separate FEC block codes, in which a single mother code (e.g., a single native LDPC code) along with multiple spawned rates can be used by suitable bit processing. In some implementations, FEC encoders (and decoders) can be multiplexed serially or in parallel.

In some implementations, a communication system can perform unequal MCS (e.g., different modulation schemes and/or coding schemes) across different bandwidth segments (e.g., OFDMA RUs). In some implementations, the system can perform different MCS on two different bandwidth segments or RUs (e.g., a lower 80MHz segment and an upper 80MHz segment in a 160MHz PHY bandwidth). For example, when an upper part/segment of the bandwidth experiences interference or is jammed, the system can use a potentially stronger FEC (e.g., LDPC code with a lower code rate) and/or a low order modulation (e.g., M-QAM with a lower value of M) for the upper part of the bandwidth while a cleaner channel segment (e.g., a lower part/segment of the bandwidth) can use a potentially weaker FEC (e.g., LDPC code with a higher code rate) and/or a higher order QAM (e.g., M-QAM with a higher value of M).

In some implementations, an OFDMA system can use different modulation and coding sets (or configurations) for different RUs, so that a better diversity gain and an overall optimum throughput can be achieved. On the other hand, when an equal modulation and coding set (or configuration) is used across different bandwidth segments or RUs which have different SNR limits, the overall performance may gravitate towards that of the worst case segment or the weakest RU.

In some implementations, a communication system (e.g., OFDMA system) can perform unequal coding (e.g., different code rates for different streams/RUs) as well as unequal modulation (e.g., different QAM schemes for different streams/RUs). In some implementations, a communication system can detect or identify unequal frequency bandwidth segments or RUs (e.g., RUs with different SNR values or different EVM values or different signal qualities or different interferences), and perform unequal LDPC coding (e.g., with different code rates) on different streams corresponding to the detected or identified unequal segments or RUs. For example, a stream transmitted using a stronger RU (referred to as "stronger stream") can potentially carry more information bits and transport data more reliably over to the receiver, than a stream transmitted using a weaker RU (referred to as "weaker stream"). A higher order QAM (e.g., 4096-QAM) can pack more information bits than a lower order QAM (e.g., 16-QAM) because the number of information bits that can be packed in M-QAM scales as $\log_2(M)$. Similarly, higher coding rates can reflect a larger number of information bits. For example, an encoding and modulation system can assign a higher code rate to a stronger stream and a lower code rate to a weaker stream.

In some implementations, an encoding and modulation system can combine an order of a modulation scheme (e.g., QAM) and a code rate (e.g., a code rate of an LDPC code) to pack a broader range of discrete information bits. In some implementations, the encoding and modulation system can determine a modulation and coding scheme (MCS) and select a pair modulation/QAM size (M) and code rate R, corresponding to the determined MCS.

In some implementations, an encoding and modulation system may include an encoding system and a modulation system. The encoding and modulation system can be implemented in hardware (e.g., circuitry or processor), firmware, software, or a combination thereof. The encoding system may include m number of scramblers (e.g., m is a number of data streams and is an integer greater than 1), m number of pre-FEC pads, m number of LDPC encoders, and/or m number of post-FEC pads. Here, a data stream refers to transmission of a sequence of data segments, transmission of a series of packets, transmission of a sequence of digitally encoded signals to convey information, or any continuous flow of data generated by various sources. The modulation system may include m number of modulations (e.g., QAM), m number of RUs (e.g., $RU_1$, $RU_2$, ..., $RU_m$), m number of inverse Fourier transforms (e.g., inverse discrete Fourier transform (IDFT) or inverse fast Fourier transform (IFFT)), m number of cyclic prefixes, m number of windowings, and/or m number of analog front ends (AFEs).

In some implementations, the encoding and modulation system can divide or split input data stream into m number of data streams. The division or split can be performed by a medium access control (MAC) layer or by a physical (PHY) layer. The m number of scramblers can randomize respective m number of data streams before encoding. The m number of pre-FEC pads can add or pad one or bits to the respective m number of data streams (or data output from the respective m number of scramblers) to generate padded data to be provided to the respective m number of LDPC encoders. The m number of LDPC encoders can encode the respective input data (or the respective padded data output from the m number of pre-FEC pads) using respective LDPC codes (which may have different code rates from each other). The m number of post-FEC pads can add or pad one or bits to data output from the respective m number of LDPC encoders to generate respective encoded data.

In some implementations, each of the m number of QAMs can determine a number of distinct symbols (or different modulation order) M and perform M-QAM (e.g., M=2, 4, 8, 16, 64, 256, ...) on the respective stream to generate a respective modulated signal. In some implementations, each QAM (or the encoding and modulation system) can determine M based on a signal quality gap (e.g., an SNR gap or an EVN gap) between the corresponding RU and another RU. In some implementations, the system may determine that an SNR gap of 3dB between two RUs corresponds to a difference of 1 bit in information bits between the two RUs. In other words, if the SNR gap between two RUs is n times 3dB (n is a positive integer), the system may determine that there are a difference of n bits in information bits between the two RUs. For example, if an SNR gap between a stronger RU and a weaker RU is 4x3dB=12dB, then the system may use 12 information bits for the stronger RU that is four more than 8 information bits for the weaker RU. Thus. the system may use 4096-QAM (12 bits) for the stronger RU and use 256-QAM (8 bits) for the weaker RU. Generally in this case, the main difference that happens in practice is interference. One segment or RU can be severely interfered by a signal from another station, compared to a different RU. Sometimes, jamming or spot interference can cause disruption to some part of the bandwidth segment.

For example, in an uncoded system, an SNR gap of 12dB can occur when there is a 4-bit difference in the number of uncoded bits between two RUs. In some implementations, a 1-bit difference between two streams can roughly translate to a 3dB SNR gap. One scenario could involve using 4096-QAM (12 bits) on stream 1 and 256-QAM (8 bits) on stream 2, resulting in a 12dB SNR gap (3dB per bit and 4-bit difference across streams). This relationship can be extended to coded systems, where an additional 3dB of SNR is needed for every 1-bit increase in information bits. Here, the information rate equals the uncoded rate multiplied by the code rate.

In some implementations, the m number of inverse Fourier transforms (e.g., IDFTs or IFFTs) can convert the respective m signals from the frequency domain to the time domain in the OFDM system, for example. The m number of cyclic prefixes can add a cyclic prefix of the last part of an OFDM symbol and append the part to the beginning of the same symbol, for respective m signals. The m number of windowings may apply a window function (e.g., rectangular window, Hamming window, Blackman window, raised cosine window, Kaiser window) to the respective m signals. The m number of AFEs can perform various functions (e.g., signal amplification, frequency conversion, filtering, analog-to-digital conversion) on the respective m signals.

In some implementations, a system can perform unequal modulation and coding across streams without having to use separate FEC block codes per different streams. In some implementations, the system can perform unequal coding across streams using multiple code rates spawned or generated by suitable bit processing based on a single mother code (e.g., a single LDPC code with a single base/mother code rate). In some implementations, a plurality of FEC encoders (and/or decoders) can be multiplexed serially or in parallel. For example, a plurality of input streams can be serially encoded using a common, single FEC encoder (e.g., LDPC encoder) that can provide multiple code rates based on a single mother code rate. Alternatively, a plurality of input streams can be encoded in parallel using a plurality of FEC encoders (e.g., LDPC encoders) corresponding to the plurality of input streams.

In some implementations, a system can determine which bits or a range of bits (e.g., information bits) are loaded, based on an a difference in signal quality (e.g., SNR gap or difference) between conditioned RUs (e.g., a stronger RU and a weaker RU) using appropriate MCS or coding parameters (e.g., a code rate R, a length of information bits k, a code block size or a code block length n). In some implementations, the system can perform selection of MCS or coding parameters (e.g., a code rate R, a length or number of information bits k, a code block size or a code block length n) to optimally load the number of information bits to reap the benefit of the SNR gap/difference, such that a maximum overall throughput can be achieved. For example, a system having a first SNR gap (between a stronger RU and a weaker RU) that is greater than a second SNR gap can select a number of information bits (for the stronger RU) greater than a number of information bits selected by a system having the second SNR gap. Similarly, a system having a first SNR gap (between a stronger RU and a weaker RU) that is greater than a second SNR gap can select a code rate (for the stronger RU) higher than a code rate selected by a system having the second SNR gap. In this manner, a system can perform unequal modulation and coding (UE-MCS) by performing different MCS schemes (e.g., multiple LDPC encoding with different code rates, multiple QAM with different values of M) across streams.

In some implementations, a system may determine a code rate $R_i$ as an MCS parameter for the $i^{th}$ stream (e.g., data stream) and determine, based on (1) a code rate R, (2) a code block length $n$, and (3) a size of information bits $k$ of a mother/base LDPC code, a size of information bits

$$\acute{k}_\iota$$

for the $i^{th}$ stream corresponding to the code rate $R_i$. In some implementations, the system may determine the value of

$$\acute{k}_\iota$$

as follows:

$$\acute{k}_\iota = n * R_i * \frac{1-\mathrm{R}}{1-R_i} \ldots\ldots\ldots \text{ (Equation 14)}.$$

In some implementations, the system may determine a code rate $R_i$ as an MCS parameter for the $i^{th}$ stream (e.g., data stream) and determine, based on (1) a code rate R and (2) a code block length n of a mother/base LDPC code, a code block length

$$\acute{n}_\iota$$

(or code block size or codeword size) for the $i^{th}$ stream corresponding to the code rate $R_i$. In some implementations, the system may determine the value of

$$\acute{n}_\iota$$

as follows:

$$\acute{n}_\iota = \mathrm{n} * \frac{1-\mathrm{R}}{1-R_i} \ldots\ldots\ldots \text{ (Equation 15)}.$$

In some implementations, the system may determine a parameter of

$$(k - \acute{k}_\iota)$$

indicating a frozen block length (or size/length of frozen bits) or a size of one or more bits added to the $\acute{k}_\iota$ information bits for the code rate $R_i$. In some implementations, the system may determine the parameter $(k - \acute{k})$ as follows:

$$(k - \acute{k}_\iota) = \frac{\mathrm{R}-R_i}{1-R_i} \ldots\ldots\ldots \text{ (Equation 16)}.$$

In some implementations, the system may calculate/compute/obtain possible combinations of parameters (e.g.,

$$\acute{k}_\iota, \acute{n}_\iota$$

) using Equation 14 to Equation 16 (such that

$$\acute{k}_\iota, \acute{n}_\iota$$

should be integer values), store the resulting parameter combinations in memory (e.g., in the form of look-up table (LUT)), and determine parameters by selecting a parameter combination from the LUT. Table 1 shows an example LUT including possible parameter combinations.

Table 1. Possible Parameter Combinations for Multi-Rate LDPC Codes

| $\acute{k}_\iota$ | $\acute{n}_\iota$ | $R_i$ | $k$ (mother code) | $n$ (mother code) | $R$ (mother code) |
|---|---|---|---|---|---|
| 1296 | 1944 | 2/3 | 1296 | 1944 | 2/3 |
| 972 | 1458 | 2/3 | 1458 | 1944 | 3/4 |
| 648 | 972 | 2/3 | 1629 | 1944 | 5/6 |

Using Table 1, the system can first determine a code rate $R_i$ and then determine/select/choose, based on the code rate $R_i$, one or more parameters $\acute{k}_\iota, \acute{n}_\iota$.

In some implementations, a system can perform unequal modulation and coding (UE-MCS) using a multi-rate LDPC code that can provide a plurality of code rates (e.g., code rates $R_i$) to encode different streams using a single mother code (or a single base code). In some implementations, the single mother code may be a single LDPC code with a base code rate (e.g., base code rate or mother code rate $R=k/n)$. A base code rate of an FEC code (e.g., LDPC code) refers to a fixed code rate or a unique code rate that is achieved by using the FEC code, In some implementations, the system can determine different code rates $R_i$ per stream. In some implementations, the system can determine different orders (or different numbers of distinct symbols) of QAM modulations per stream.

In some implementations, the system can realize, implement, or provide different code rates per stream by performing appropriate pre-processing. In some implementations, for m streams (or data streams; m is an integer greater than 1), the pre-processing can include selection of code rates $R_1$, $R_2$, ... , $R_m$ based on conditions of m RUs corresponding to the m streams (e.g., signal qualities, interferences, SNR gaps between RUs, EVM gaps between RUs) such that a higher code rate can be selected for (or assigned to) a stronger RU. In some implementations, for m streams, the pre-processing can include selection of block coding parameters

$$\acute{k}_\iota, \acute{k}_2, .., \acute{k}_m$$

corresponding to the code rates $R_1$, $R_2$, ... , $R_m$ using Equation 14, for example. In some implementations, for m streams, the pre-processing can include selection of block coding parameters $\acute{n}_1$, $\acute{n}_2$, ..., $\acute{n}_m$ corresponding to the code rates $R_1$,

$$\acute{k}_\iota, \acute{k}_2 :$$

$R_2$, ... , $R_m$ using Equation 15, for example. For example, when m=2, the system can determine $\quad$, for rates $R_1$, $R_2$, and/or determine $\acute{n}_1$, $\acute{n}_2$ for rates $R_1$, $R_2$.

In some implementations, a plurality of input streams can be serially encoded using a common, a single mother (or base) LDPC code that can provide, based on a single mother code rate, multiple code rates corresponding to the plurality of input streams. Alternatively, a plurality of input streams can be encoded in parallel using a common, a single mother (or base) LDPC code that can provide, based on a single mother code rate, multiple code rates corresponding to the plurality of input streams.

In some implementations, a system can split or divide data (e.g., a single data stream) into a plurality of different types of data (e.g., type-1, type-2, ..., type-m; m is an integer greater than 1). In some implementations, different types of data may indicate different traffic types (e.g., video, text, audio). In some implementations, the system can split or divide data into the plurality of different types of data at a MAC layer or a MAC level. In some implementations, the plurality of different types of data may have different degrees or levels of quality of service (QoS). In some implementations, the plurality of different types of data may have different (or unequal) levels of priority (e.g., different levels of protection of data). In some implementations, the plurality of different types of data may correspond to a plurality of streams (e.g., $m$ number of streams).

In some implementations, the system can determine a size of information bits

$$\acute{k}_\iota\, 1$$

for type-i data (e.g., i is an integer greater than or equal to 1) and perform padding on the type-i data to increase the size of the type-i data to be equal to

$$\acute{k}_\iota$$

or a nearest size of information bits. In some implementations, the system can perform padding by (1) determining a size of padded data, (2) generating random data with the determined size of padded data, and/or (3) adding the generated data (as padded data) to the type-i data. In some implementations, the system can perform padding by (1) determining a size of padded data and (2) generating data having same bit values (e.g., zero) with the determined size of padded data, and/or (3) adding the generated data (as padded data) to the type-i data.

For example, for two types of split data (e.g., type-1 data and type-2 data), the system can determine a size or length of the type-1 data (e.g., a payload length of the type-1 data) and a size or length of the type-2 data (e.g., a payload length of the type-2 data). The system can (1) determine a size of information bits $\acute{k}_1$ for the type-1 data, (2) divide the type-1 data into a data portion with a size of multiples of the size of information bits $\acute{k}_1$ and a remaining portion $\Delta_1$ with a size less than the size of information bits $\acute{k}_1$, and/or (3) add or append padded data (with a size of $(\acute{k}_1 - \Delta_1)$) to the remaining portion $\Delta_1$ to increase the size of the remaining portion to the size of information bits $\acute{k}_1$. The system can (1) determine a size of information bits $\acute{k}_2$ for the type-2 data, (2) divide the type-2 data into a data portion with a size of multiples of the size of information bits $\acute{k}_2$ and a remaining portion $\Delta_2$ with a size less than the size of information bits $\acute{k}_2$, and/or (3) add or append padded data (with a size of $(\acute{k}_2 - \Delta_2)$) to the remaining portion $\Delta_2$ to increase the size of the remaining portion to the size of information bits $\acute{k}_2$.

In some implementations, a system can split or divide data into a plurality of different data streams at a PHY layer or a PHY level (PHY split). In some implementations, in response to data arriving (or being received) at the PHY layer as a single stream, the system can split or divide the single stream into a plurality of data streams at the PHY layer or the PHY level. In some implementations, for m (split) data streams, the system can determine sizes of information bits

$$\acute{k}_\iota,\ \acute{k}_2,\ ..,\ \acute{k}_m$$

and split or divide the single stream into a plurality of data streams according to the determined sizes of information bits

$$\acute{k}_\iota,\ \acute{k}_2,\ ..,\ \acute{k}_m\,.$$

In some implementations, the system can perform PHY split by limiting pre-FEC padding to one of the (split) data streams (depending on the payload length of the single stream before the PHY split).

In one example of PHY split, for a single data stream, the system can determine a size or length of the single data stream (e.g., a payload length of the single data stream) and a number of split data streams (e.g., 2) at the PHY layer. The system can (1) determine a size of information bits $\acute{k}_1$ for the data stream 1 and a size of information bits $\acute{k}_2$ for the data stream 2, (2) split or divide the single data stream into a plurality of first data portions each with a size equal to $\acute{k}_2$ and a plurality of second data portions each with a size equal to $\acute{k}_2$ such that the number of the first data portions is equal to the number of the second data portions, (3) determine a remaining portion $\Delta_1$ at the end of the single data stream whose size is less than $\acute{k}_\iota,$ and/or (4) add or append padded data (with a size of $(\acute{k}_1 - \Delta_1)$) to the remaining portion $\Delta_1$ to increase the size of the remaining portion to the size of information bits $\acute{k}_1.$

In another example of PHY split, for a single data stream, the system can determine a size or length of the single data stream (e.g., a payload length of the single data stream) and a number of split data streams (e.g., 2). The system can (1) determine a size of information bits $\acute{k}_1$ for the data stream 1 and a size of information bits $\acute{k}_2$ for the data stream 2, (2) split or divide the single data stream into a plurality of first data portions each with a size equal to $\acute{k}_\iota$ and a plurality of second data portions each with a size equal to $\acute{k}_2$ such that the number of the first data portions is equal to the number of the second data portions, (3) determine a remaining portion at the end of the single data stream whose size is greater than $\acute{k}_\iota$, (4) divide the remaining portion into a first remaining portion $\Delta_1$ with a size equal to $\acute{k}_\iota$ and a second remaining portion $\Delta_2$ with a size less than $\acute{k}_2$ and/or (5) add or append padded data (with a size of $(\acute{k}_2 - \Delta_2)$) to the second remaining portion $\Delta_2$ to increase the size of the second remaining portion to the size of information bits $\acute{k}_2$.

In some implementations, a system can encode a plurality of types of data (or plurality of data streams) with a fixed code block length (e.g., n) using a plurality of code rates generated by a single LDPC encoder (or a single LDPC code). For example, a system can split or divide input data into type-1 data and type-2 data at the MAC layer. The system can determine code rates $R_1$ and $R_2$ for the type-1 data and the type-2 data based on conditions of RUs (e.g., SNR gap/difference between the RUs). The system can determine or pre-compute, based on the code rates $R_1$ and $R_2$, coding parameters to encode the type-1 data and the type-2 data (e.g., $\acute{k}_1$, $\acute{k}_2$, $\acute{n}_1$, $\acute{n}_2$) using Equation 14 and/or Equation 15. The system can (1) add or append first padded data (e.g., using a pre-FEC pad) at an end of the type-1 data to increase the size of the type-1 data to $\acute{k}_\iota$ and (2) add or append second padded data (e.g., using a pre-FEC pad) at an end of the type-2 data to increase the size of the type-2 data to $\acute{k}_2$. In order to encode the type-1 data using a single LDPC code with a base rate R (e.g., R=k/n), the system can determine a size $\theta = (k - \acute{k}_\iota)$ using Equation 16 and add a plurality of first frozen blocks each with the determined size $(k - \acute{k}_\iota)$ to the type-1 data (e.g., using a pre-FEC pad). In order to encode the type-2 data using the same single LDPC code, the system can determine a size $\theta_2 = (k - \acute{k}_2)$ using Equation 16 and add a plurality of second frozen blocks each with the determined size $(k - \acute{k}_2)$ to the type-2 data (e.g., using a pre-FEC pad).

In some implementations, the system can perform LDPC encoding on the type-1 data using the single LDPC code to generate a first codeword with size n. The system can also perform LDPC encoding on the type-2 data using the single LDPC code to generate a second codeword with size n. In some implementations, the system can execute or run a (single) LDPC encoder on the type-1 data and the type-2 data in a time multiplexed manner. In some implementations, the system can execute or run two LDPC encoders (with the same mother code) on the type-1 data and the type-2 data in parallel. In some implementations, the system can perform shortening by (1) removing or discarding the plurality of first frozen blocks from the first codeword to generate first encoded data (with the code rate $R_1$) corresponding to the type-1 data, and/or (2) removing or discarding the plurality of second frozen blocks from the second codeword to generate second encoded data (with the code rate $R_2$) corresponding to the type-2 data. In this manner, for example, code rates $R_1 = \frac{3}{4}$, $R_2 = \frac{2}{3}$ can be derived from $R = \frac{5}{6}$. In some implementations, upon discarding the first and second frozen blocks, the system can provide or send the first encoded data and the second encoded data to QAM (e.g., QAM with different values of M).

In some implementations, a system can encode a plurality of types of data (or plurality of data streams) with a plurality of code block lengths (e.g., $n_1$, $n_2$, ...) using a plurality of native code rates provided by a plurality of LDPC encoders (or a plurality of LDPC codes). For example, a system with can split or divide input data into data stream 1 and data stream 2 at the MAC layer or the PHY layer. The system can determine native code rates $R_1$ ($=k_1/n_1$) and $R_2$ ($=k_2/n_2$) for the data stream 1 and the data stream 2, respectively, based on conditions of RUs (e.g., SNR gap/difference between the RUs). The system can determine coding parameters to encode the data stream 1 and the data stream 2 (e.g., $k'_1$, $k'_2$) based on conditions of RUs. The system can (1) divide the data stream 1 into a plurality of information blocks each with a size $\acute{k}_1$, (2) divide the data stream 2 into a plurality of information blocks each with a size $\acute{k}_2$, (3) add a plurality of first padded data or frozen blocks (e.g., using a pre-FEC pad) each with a size $(k_1 - k'_1)$ to increase the size of each information block to $k_1$, and/or (4) add a plurality of second padded data or frozen blocks (e.g., using a pre-FEC pad) each with a size $(k_2 - \acute{k}_2)$ to increase the size of each information block to $k_2$.

In some implementations, the system can perform LDPC encoding on the data stream 1 using an LDPC code with a native code rate $R_1$ (=$k_1/n_1$) to generate a first codeword with size $n_1$. The system can also perform LDPC encoding on the data stream 2 using an LDPC code with a native code rate $R_2$ (=$k_2/n_2$) to generate a second codeword with size $n_2$. In some implementations, the system can execute or run two LDPC encoders (with code rates $R_1$ and $R_2$ respectively) on the data stream 1 and the data stream 2 in a time multiplexed manner. In some implementations, the system can execute or run two LDPC encoders (with code rates $R_1$ and $R_2$ respectively) on the data stream 1 and the data stream 2 in parallel. In some implementations, the system can perform shortening by (1) removing or discarding the plurality of first frozen blocks from the first codeword to generate first encoded data (with the code rate $R_1$) corresponding to the data stream 1, and/or (2) removing or discarding the plurality of second frozen blocks from the second codeword to generate second encoded data (with the code rate $R_2$) corresponding to the data stream 2. In some implementations, upon discarding the first and second frozen blocks, the system can provide or send the first encoded data and the second encoded data to QAM (e.g., QAM with different values of M).

In some implementations, a system can encode a plurality of types of data (or plurality of data streams) with a plurality of code block lengths (e.g., $n_1$, $n_2$, ...) using a plurality of native code rates provided by a plurality of LDPC encoders (or a plurality of LDPC codes). For example, a system can split or divide input data into data stream 1 and data stream 2 at the MAC layer or the PHY layer. The system can determine native code rates $R_1$ (=$k_1/n_1$) and $R_2$ (=$k_2/n_2$) for the data stream 1 and the data stream 2, respectively, based on conditions of RUs (e.g., SNR gap/difference between the RUs). The system can (1) divide the data stream 1 into a plurality of information blocks each with a size $k_1$, and (2) divide the data stream 2 into a plurality of information blocks each with a size $k_2$. In some implementations, the system can perform LDPC encoding on the data stream 1 using an LDPC code with a native code rate $R_1$ (=$k_1/n_1$) to generate a first codeword with size $n_1$ (as first encoded data). The system can also perform LDPC encoding on the data stream 2 using an LDPC code with a native code rate $R_2$ (=$k_2/n_2$) to generate a second codeword with size $n_2$ (as second encoded data). In some implementations, the system can execute or run two LDPC encoders (with code rates $R_1$ and R2 respectively) on the data stream 1 and the data stream 2 in a time multiplexed manner. In some implementations, the system can execute or run two LDPC encoders (with code rates $R_1$ and R2 respectively) on the data stream 1 and the data stream 2 in parallel. In some implementations, upon completion of the encoding of the data stream 1 and the data stream 2, the system can provide or send the first encoded data and the second encoded data to QAM (e.g., QAM with different values of M).

For example, a system can use a 1024-QAM and a code rate $R_1$=5/6 for a data stream 1, and a 256-QAM and a code rate $R_2$=2/3 for a data stream 2. In a first embodiment, the system can (1) perform LDPC coding with a native code rate R=5/6 (e.g., n=1944, k=1620) on the data stream 1 to generate first encoded data, (2) perform LDPC coding with a native code rate R=2/3 (e.g., n=1944, k=1296) on the data stream 2 to generate second encoded data, and/or (3) map the first encoded data and the second encoded data to the 1024-QAM and the 256-QAM, respectively.

In a second embodiment, the system can (1) determine coding parameters $\acute{k}_1$ (=1620) and $\acute{k}_2$ (=648) to encode the data stream 1 and the data stream 2, respectively (e.g., based on conditions of RUs), (2) split or divide the data stream 1 into a plurality of first blocks each with a size $k_1$' = $k$ =1620, (3) split or divide the data stream 2 into a plurality of second blocks each with a size $\acute{k}_2$ = 648, (4) add or append a frozen block with a size $\theta = k - k_2$' = 1620 - 648 = 972 bits, to each of the second blocks, (5) perform LDPC encoding with a native code rate R=k/n=1620/1944=5/6 on the data stream 1 and the (padded) data stream 2 to generate a first codeword and a second codeword, respectively, (6) discard the frozen blocks (each with 972 bits) from the systematic positions (e.g., portions except parity bits) to generate first encoded data and second encoded data, and/or (7) multiplex the first encoded data and the second encoded data to perform stream-wise QAM modulations (with different values of M).

In a third embodiment, the system can (1) perform LDPC coding with a native code rate R=5/6 on the data stream 1 to generate first encoded data and LDPC coding with a native code rate R=2/3 on the data stream 2 to generate second encoded data, in a time multiplexed manner, and/or (2) map the first encoded data and the second encoded data to the 1024-QAM and the 256-QAM, respectively.

Embodiments in the present disclosure have at least the following advantages and benefits. First, embodiments in the present disclosure can provide useful techniques for constructing/generating/configuring/designing/implementing multi-rate LDPC codes to perform unequal coding for different data streams transmitted using different RUs to mitigate interferences caused by the presence of noise, other wireless device (e.g., OBSS), other wireless signals (e.g., signal jamming due to a jammer), or other interference (e.g., EMI, ICI, etc.). In this manner, in the presence of unequal conditions in different RUs (e.g., a large SNR gap between RUs), a multi-rate LDPC code can be used to encode a plurality of streams with different code rates determined based on the unequal conditions of the RUs. For example, if there are a strongest RU and a weakest RU, a higher code rate and a larger size of information bits can be used to encode a data stream corresponding the strongest RU, while a lower code rate and a smaller size of information bits can be used to encode a data stream corresponding the weakest RU.

Second, embodiments in the present disclosure can provide useful techniques for mapping different modulation schemes (e.g., QAM with different values of M) to data streams corresponding to different RUs having unequal conditions (e.g., a large SNR gap between RUs) to mitigate interferences. For example, if there are a strongest RU and a weakest RU, a QAM with a larger value of M (e.g., 4096-QAM) can be used to modulate a data stream corresponding the strongest RU, while a QAM with a smaller value of M (e.g., 16-QAM) can be used to modulate a data stream corresponding the weakest RU.

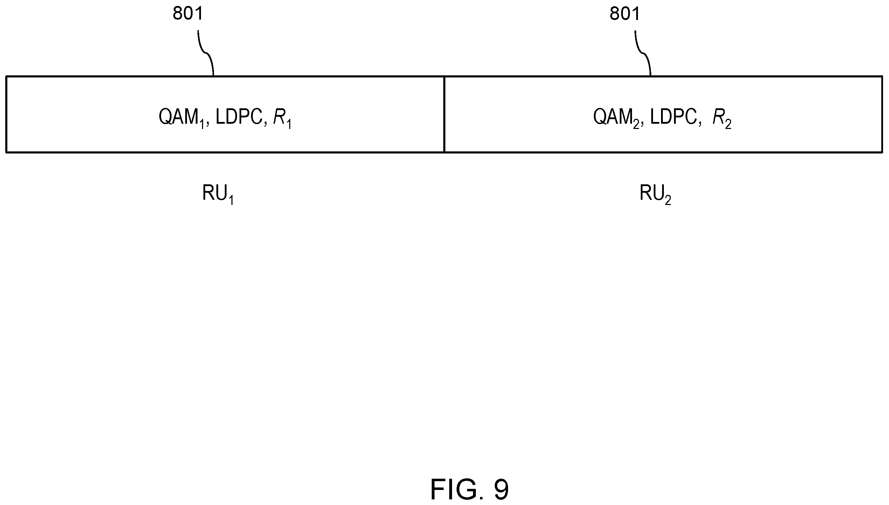

Referring to FIGS. 9-17, embodiments of systems and methods for the present solution to provide unequal encoding and modulation are described and illustrated.

FIG. 9 is a diagram depicting different modulation and coding configurations across different RUs, according to one or more embodiments. In some implementations, a communication system can perform unequal MCS (e.g., different modulation schemes and/or coding schemes) across different bandwidth segments (e.g., OFDMA RUs). Referring to FIG. 9, the system can perform different MCS on $RU_1$ 801 and $RU_2$ 802 (e.g., a lower 80MHz segment and an upper 80MHz segment in a 160MHz PHY bandwidth). For example, when an upper part/segment of the bandwidth (e.g., $RU_2$ 802) experiences interference or is jammed, the system can use a potentially stronger FEC (e.g., LDPC code with a lower code rate $R_2$) and/or a low order modulation (e.g., M-$QAM_2$ with a lower value of $M=M_1$) for the $RU_2$ 802 while a cleaner channel segment (e.g., a lower part/segment of the bandwidth or $RU_1$ 801) can use a potentially weaker FEC (e.g., LDPC code with a higher code rate $R_2$ such that $R_2 > R_1$) and/or a higher order QAM (e.g., M-$QAM_1$ with a higher value of $M=M_2$ such that $M_2 > M_1$).

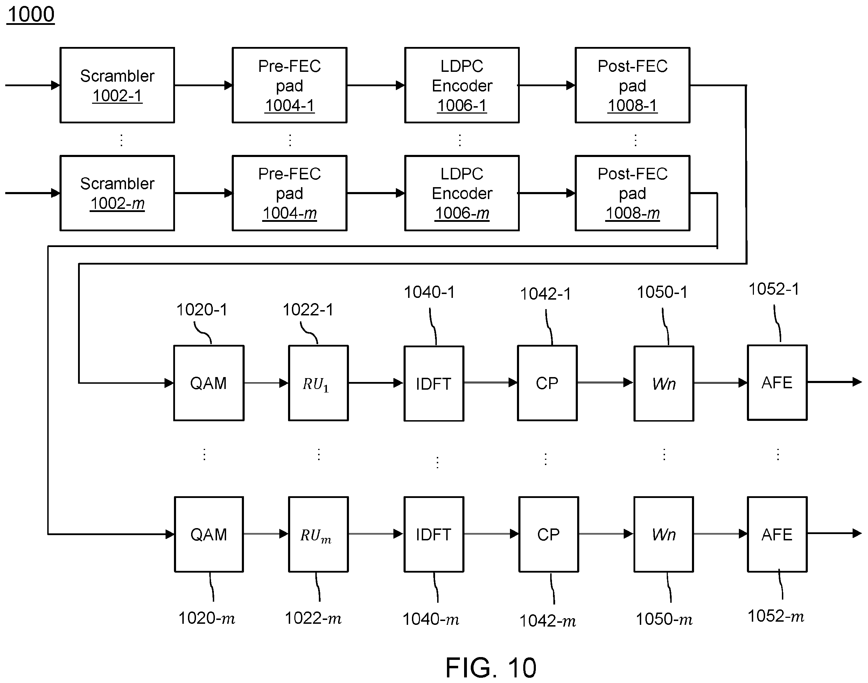

FIG. 10 is a diagram depicting an example encoding and modulation system 1000 with across different RUs, according to one or more embodiments. An encoding and modulation system 1000 may include an encoding system and a modulation system. The encoding and modulation system 1000 can be implemented in hardware (e.g., circuitry or processor), firmware, software, or a combination thereof. The encoding system may include m number of scramblers 1002-1, ..., 1002-m (e.g., m is a number of data streams and is an integer greater than 1), m number of pre-FEC pads 1004-1, ..., 1004-m, m number of LDPC encoders 1006-1, ..., 1006-m, and/or m number of post-FEC pads 1008-1, ..., 1008-m. The modulation system may include m number of modulations (e.g., QAMs) 1020-1, ..., 1020-m, m number of RUs 1022-1, ..., 1022-m (e.g., $RU_1$, $RU_2$, ..., $RU_m$), m number of inverse Fourier transforms 1040-1, ..., 1040-m (e.g., inverse discrete Fourier transform (IDFT) or inverse fast Fourier transform (IFFT)), m number of cyclic prefixes 1042-1, ..., 1042-m, m number of windowings 1050-1, ..., 1050-m, and/or m number of analog front ends (AFEs) 1052-1, ..., 1052-m.

The encoding and modulation system can 1000 divide or split input data stream into m number of data streams. The division or split can be performed by a medium access control (MAC) layer or by a physical (PHY) layer. The m number of scramblers 1002-1, ..., 1002-m can randomize respective m number of data streams before encoding. The m number of pre-FEC pads 1004-1, ..., 1004-m can add or pad one or bits to the respective m number of data streams (or data output from the respective m number of scramblers) to generate padded data to be provided to the respective m number of LDPC encoders 1006-1, ..., 1006-m. The m number of LDPC encoders 1006-1, ..., 1006-m can encode the respective input data (or the respective padded data output from the m number of pre-FEC pads 1004-1, ..., 1004-m) using respective LDPC codes (which may have different code rates from each other). The m number of post-FEC pads 1008-1, ..., 1008-m can add or pad one or bits to data output from the respective m number of LDPC encoders 1006-1, ..., 1006-m to generate respective encoded data.

Each of the m number of QAMs 1020-1, ..., 1020-m can determine a number of distinct symbols (or different modulation order) M and perform M-QAM (e.g., M=2, 4, 8, 16, 64, 256, ...) on the respective stream to generate a respective modulated signal. In some implementations, each QAM (or the encoding and modulation system) can determine M based on a signal quality gap (e.g., an SNR gap or an EVN gap) between the corresponding RU and another RU. For example, if an SNR gap between a stronger RU and a weaker RU is 3x3dB, then the system may use information bits (e.g., m=6 bits) for the stronger RU that is three more than the information bits (m=3 bits) for the weaker RU. Because $M = 2^{2m}$. the system may use 4096-QAM for the stronger RU and use 64-QAM for the weaker RU.

The m number of inverse Fourier transforms (e.g., IDFTs or IFFTs) 1040-1, ..., 1040-m can convert the respective m signals from the frequency domain to the time domain in the OFDM system, for example. The m number of cyclic prefixes 1042-1, ..., 1042-m can add a cyclic prefix of the last part of an OFDM symbol and append the part to the beginning of the same symbol, for respective m signals. The m number of windowings 1050-1, ..., 1050-m may apply a window function (e.g., rectangular window, Hamming window, Blackman window, raised cosine window, Kaiser window) to the respective m signals. The m number of AFEs 1052-1, ..., 1052-m can perform various functions (e.g., signal amplification, frequency conversion, filtering, analog-to-digital conversion) on the respective m signals.

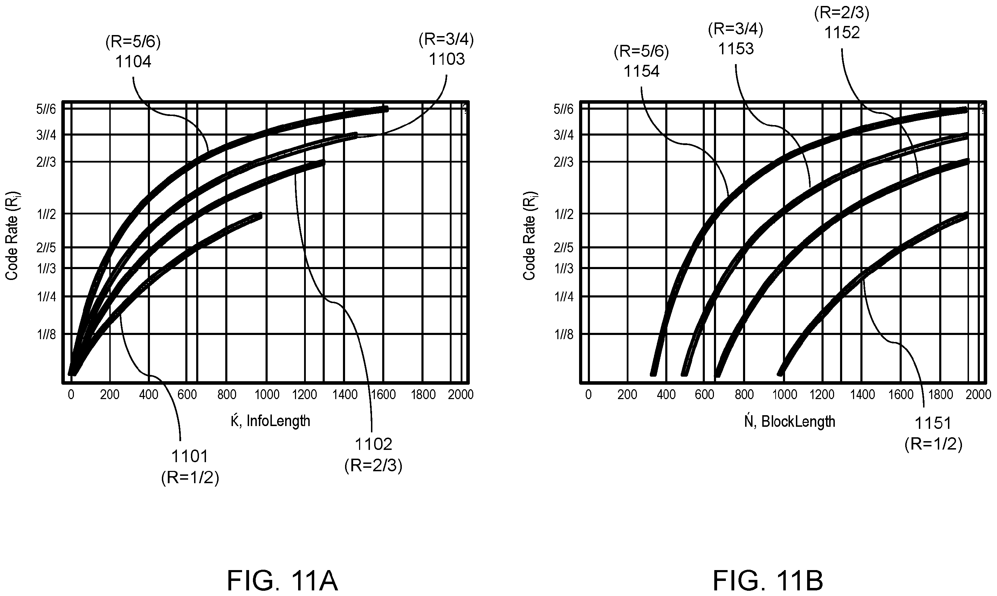

FIG. 11A and FIG. 11B are diagrams depicting example parameters with different multi-rate LDPC codes according to one or more embodiments. FIG. 11A shows how to determine coding parameters (e.g., a length of information bits $\acute{k}$) based on a native code rate $R$ of a mother code and a desired code rate $R_i$ for a the $i^{th}$ data stream when the code block length n=1944. Referring to FIG. 11A, lines 1101, 1102, 1103, 1104 correspond to desired coding parameters (e.g., a code rate $R_i$, a length of information bits k) for the native code rate R=1/2, 2/3, ¾, 5/6, respectively. Given the native code rate R, a length of information bits $\acute{k}$ can be determined by rounding to a nearest natural number for the length of information bits along the line corresponding to the code rate R (rounding up/down can result in a slight increase/decrease of code rates).

FIG. 11B shows how to determine coding parameters (e.g., a code block length $\acute{n}$) based on a native code rate R

of a mother code and a desired code rate $R_i$ for a the $i^{th}$ data stream when the code block length n=1944. Referring to FIG. 11B, lines 1151, 1152, 1153, 1154 correspond to desired coding parameters (e.g., a code rate $R_i$, a code block $ń$) for the native code rate R=1/2, 2/3, ¾, 5/6, respectively. Given the native code rate R, a code block length $ń$ can be determined by rounding to a nearest natural number for the code block length along the line corresponding to the code rate R (rounding up/down can result in a slight increase/decrease of code rates).

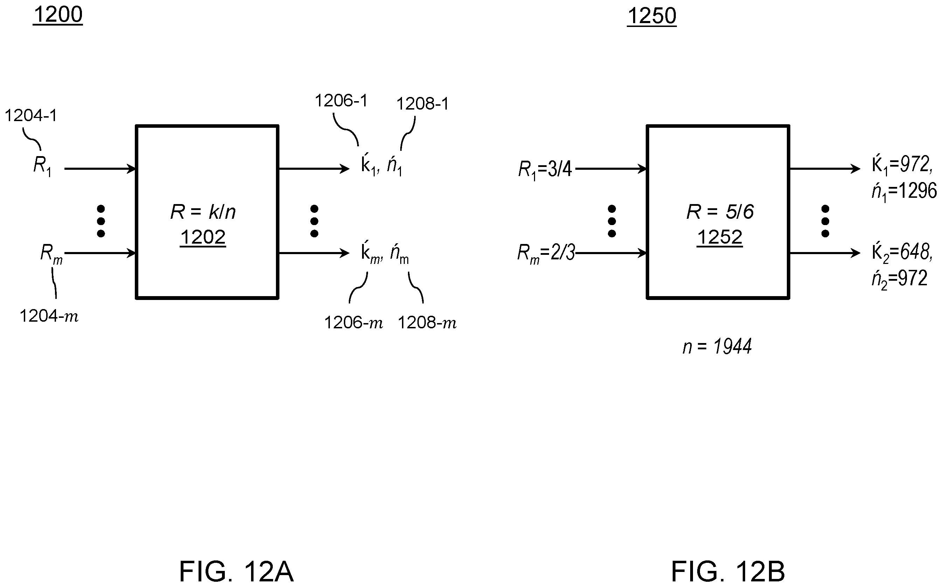

FIG. 12A and FIG. 12B are block diagrams 1200, 1250 depicting example input and output parameters for multi-rate LDPC codes 1202, 1252 according to one or more embodiments. A system (e.g., communication system 105) can perform unequal modulation and coding (UE-MCS) using a multi-rate LDPC code that can provide a plurality of code rates (e.g., code rates $R_i$) to encode different streams using a single mother code (or a single base code). The single mother code may be a single LDPC code with a base code rate (e.g., base code rate or mother code rate $R=k/n$). The system can determine different code rates $R_i$ per stream (e.g., 1204-1, ..., 1204-m; m is the number of data streams. The system can realize, implement, or provide different code rates per stream by performing appropriate pre-processing. For m streams (or data streams; m is an integer greater than 1), the pre-processing can include selection of code rates $R_1, R_2, ..., R_m$ (e.g., 1204-1, ..., 1204-m) based on conditions of m RUs corresponding to the m streams (e.g., signal qualities, interferences, SNR gaps between RUs, EVM gaps between RUs) such that a higher code rate can be selected for (or assigned to) a stronger RU. For m streams, the pre-processing can include selection of block coding parameters $\acute{k}_1, \acute{k}_2, .., \acute{k}_m$ (e.g., 1206-1, ..., 1206-m) corresponding to the code rates $R_1, R_2, ..., R_m$ using Equation 14, for example. For m streams, the pre-processing can include selection of block coding parameters $ń_1, ń_2, ..., ń_m$ (e.g., 1208-1, ..., 1208-m) corresponding to the code rates $R_1, R_2, ..., R_m$ using Equation 15, for example. Referring to FIG. 12B, when m=2, the system can determine

$$\acute{k}_1 = 972, \quad k_2 = \acute{648}$$

for rates $R_1$=3/4, $R_2$=2/3, and/or determine $n_1$ ='1296, $n_2 = \acute{972}$ for rates $R_1$=3/4, $R_2$=2/3, using the multi-rate LDPC code 1252 based on the base code rate 5/6.

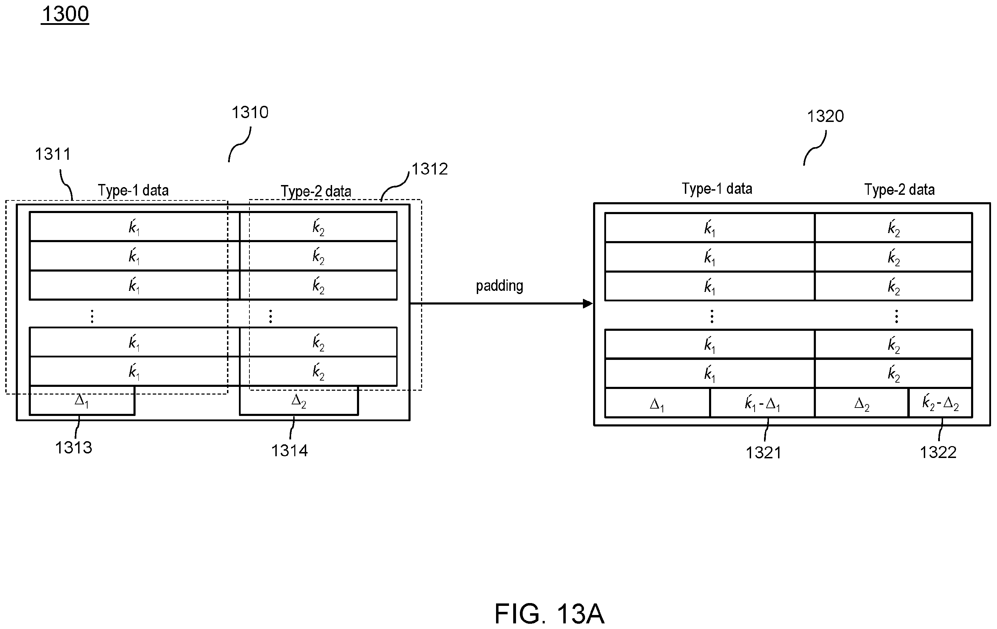

FIG. 13A to FIG. 13C are diagrams 1300, 1330, 1360 depicting example processes of splitting data by a medium access control (MAC) layer or a physical (PHY) layer, according to one or more embodiments. Referring to FIG. 13A, for two types of split data (e.g., type-1 data and type-2 data), a system can determine a size or length of the type-1 data (e.g., a payload length of the type-1 data) and a size or length of the type-2 data (e.g., a payload length of the type-2 data). In process step 1310, the system can (1) determine a size of information bits $\acute{k}_1$ for the type-1 data, (2) divide the type-1 data into a data portion 1311 with a size of multiples of the size of information bits $\acute{k}_1$ and a remaining portion $\Delta_1$ (1313) with a size less than the size of information bits $\acute{k}_1$, (3) determine a size of information bits $\acute{k}_2$ for the type-2 data, (2) divide the type-2 data into a data portion 1312 with a size of multiples of the size of information bits $\acute{k}_2$ and a remaining portion $\Delta_2$ (1314) with a size less than the size of information bits $\acute{k}_2$. In process step 1320, the system can (1) add or append padded data 1321 (with a size of $(\acute{k}_1 - \Delta_1)$) to the remaining portion $\Delta_1$ to increase the size of the remaining portion to the size of information bits $\acute{k}_1$, and (2) add or append padded data 1322 (with a size of $(\acute{k}_2 - \Delta_2)$) to the remaining portion $\Delta_2$ to increase the size of the remaining portion to the size of information bits $\acute{k}_2$. The processes shown in FIG. 13A can be performed at the MAC layer.

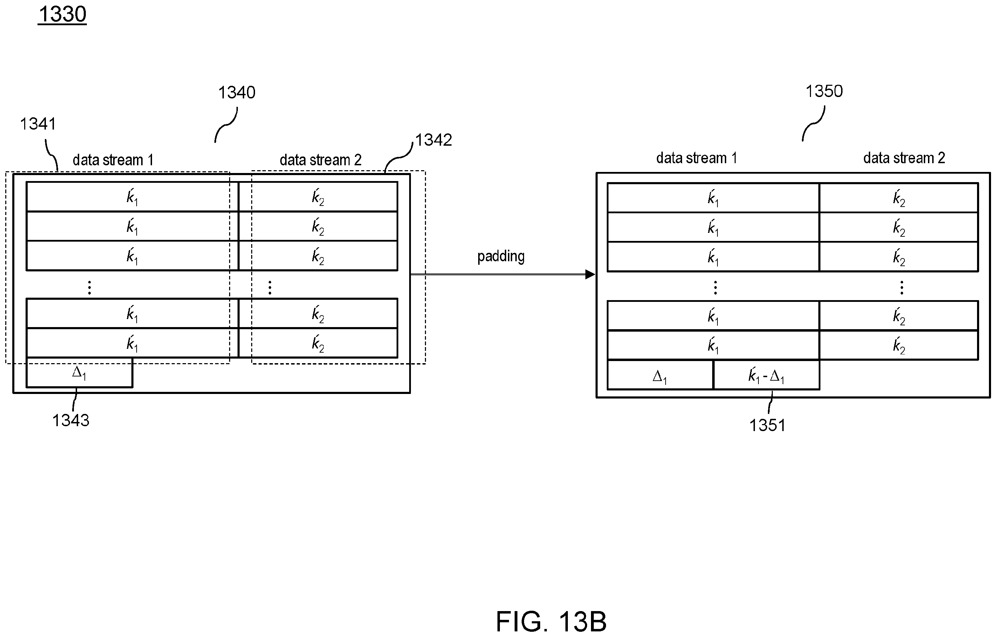

In some implementations, a system can split or divide data into a plurality of different data streams (e.g., data stream 1, data stream 2 in FIG. 13B) at a PHY layer or a PHY level (PHY split). In response to data arriving (or being received) at the PHY layer as a single stream, the system can split or divide the single stream into a plurality of data streams (e.g., data stream 1, data stream 2) at the PHY layer or the PHY level. For m (split) data streams, the system can determine sizes of information bits $\acute{k}_1, \acute{k}_2, .., \acute{k}_m$ and split or divide the single stream into a plurality of data streams according to the determined sizes of information bits $\acute{k}_1, \acute{k}_2, .., \acute{k}_m$. In some implementations, the system can perform PHY split by limiting pre-FEC padding to one of the (split) data streams (depending on the payload length of the single stream before the PHY split).

FIG. 13B shows an example of PHY split in which for a single data stream, the system can determine a size or length of the single data stream (e.g., a payload length of the single data stream) and a number of split data streams (e.g., 2) at the PHY layer. In process step 1340, the system can (1) determine a size of information bits $\acute{k}_1$ for the data stream 1 and a size of information bits $\acute{k}_2$ for the data stream 2, (2) split or divide the single data stream into a plurality of first data portions 1341 each with a size equal to $\acute{k}_1$ and a plurality of second data portions 1342 each with a size equal to $\acute{k}_2$ such that the number of the first data portions is equal to the number of the second data portions, (3) determine a remaining portion $\Delta_1$ (1343) at the end of the single data stream whose size is less than $\acute{k}_1$. In process step 1350, the system can add or append padded data 1351 (with a size of $(\acute{k}_1 - \Delta_1)$) to the remaining portion $\Delta_1$ to increase the size of the remaining portion to the size of information bits $\acute{k}_1$.

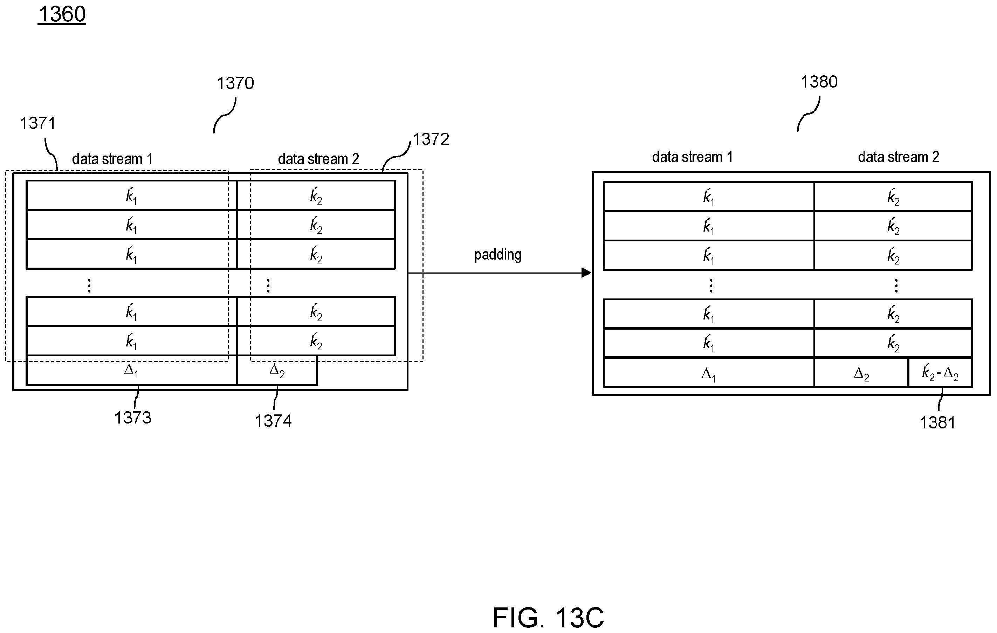

FIG. 13C shows another example of PHY split in which for a single data stream, the system can determine a size or length of the single data stream (e.g., a payload length of the single data stream) and a number of split data streams (e.g., 2). In process step 1370, the system can (1) determine a size of information bits $\acute{k}_1$ for the data stream 1 and a size of information bits $\acute{k}_2$ for the data stream 2, (2) split or divide the single data stream into a plurality of first data portions 1371 each with a size equal to $\acute{k}_\iota$ and a plurality of second data portions 1372 each with a size equal to $\acute{k}_2$ such that the number of the first data portions is equal to the number of the second data portions, (3) determine a remaining portion at the end of the single data stream whose size is greater than $\acute{k}_\iota$, (4) divide the remaining portion into a first remaining portion $\Delta_1$ (1373) with a size equal to $\acute{k}_\iota$ and a second remaining portion $\Delta_2$ (1374) with a size less than $\acute{k}_2$. In process step 1380, the system can add or append padded data 1381 (with a size of $(\acute{k}_2 - \Delta_2)$) to the second remaining portion $\Delta_2$ to increase the size of the second remaining portion to the size of information bits $\acute{k}_2$.

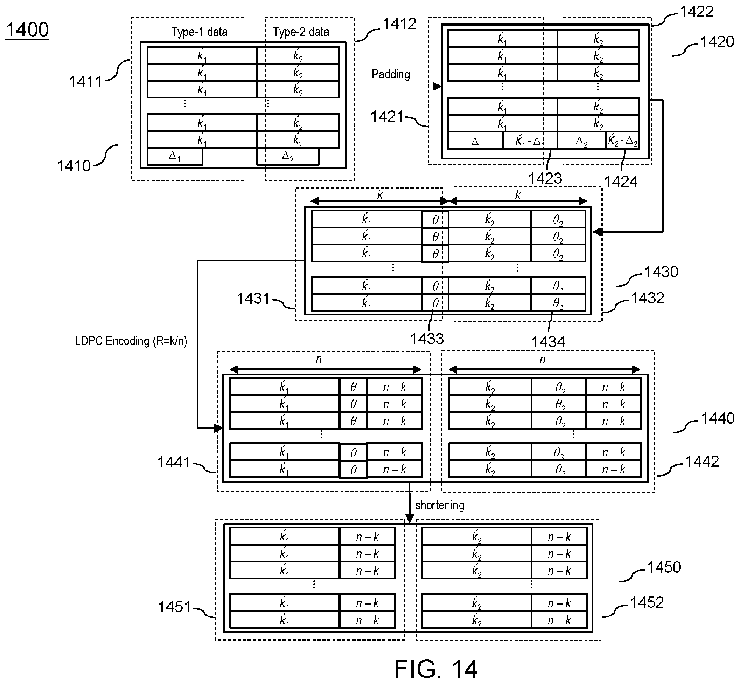

FIG. 14 is a diagram 1400 depicting an example process of encoding data with two code rates using a single LDPC encoder, according to one or more embodiments. In some implementations, a system can encode a plurality of types of data (or plurality of data streams) with a fixed code block length (e.g., n) using a plurality of code rates generated by a single LDPC encoder (or a single LDPC code). Referring to FIG. 14, in process step 1410, a system can split or divide input data into type-1 data 1411 and type-2 data 1412 at the MAC layer. The system can determine code rates $R_1$ and $R_2$ for the type-1 data and the type-2 data based on conditions of RUs (e.g., SNR gap/difference between the RUs). The system can determine or pre-compute, based on the code rates $R_1$ and $R_2$, coding parameters to encode the type-1 data and the type-2 data (e.g., $\acute{k}_1$, $\acute{k}_2$, $\acute{n}_1$, $\acute{n}_2$) using Equation 14 and/or Equation 15. In process step 1420, the system can (1) add or append first padded data 1423 (e.g., using a pre-FEC pad 1004-1) at an end of the type-1 data 1421 to increase the size of the type-1 data to $\acute{k}_\iota$ and (2) add or append second padded data 1424 (e.g., using a pre-FEC pad 1004-2) at an end of the type-2 data 1422 to increase the size of the type-2 data to $\acute{k}_2$. In process step 1430, in order to encode the type-1 data 1431 using a single LDPC code with a base rate R (e.g., R=k/n), the system can determine a size $\theta = (k - \acute{k}_\iota)$ using Equation 16 and add a plurality of first frozen blocks 1433 each with the determined size $(k - \acute{k}_\iota)$ to the type-1 data (e.g., using a pre-FEC pad 1004-1). In order to encode the type-2 data 1432 using the same single LDPC code, the system can determine a size $\theta_2 = (k - \acute{k}_2)$ using Equation 16 and add a plurality of second frozen blocks 1434 each with the determined size $(k - \acute{k}_2)$ to the type-2 data (e.g., using a pre-FEC pad 1004-2).

Referring to FIG. 14, in process step 1440, the system can perform LDPC encoding on the type-1 data using the single LDPC code to generate a first codeword 1441 with size n. The system can also perform LDPC encoding on the type-2 data using the single LDPC code to generate a second codeword 1442 with size n. The system can execute or run a (single) LDPC encoder on the type-1 data and the type-2 data in a time multiplexed manner. In some implementations, the system can execute or run two LDPC encoders (with the same mother code) on the type-1 data and the type-2 data in parallel. In process step 1450, the system can perform shortening by (1) removing or discarding the plurality of first frozen blocks 1433 from the first codeword to generate first encoded data 1451 (with the code rate $R_1$) corresponding to the type-1 data, and/or (2) removing or discarding the plurality of second frozen blocks 1434 from the second codeword to generate second encoded data 1452 (with the code rate $R_2$) corresponding to the type-2 data. In this manner, for example, code rates $R_1$=¾, $R_2$=⅔ can be derived from $R = \frac{5}{6}$. In some implementations, upon discarding the first and second frozen blocks, the system can provide or send the first encoded data 1451 and the second encoded data 1452 to QAM (e.g., QAM with different values of M).

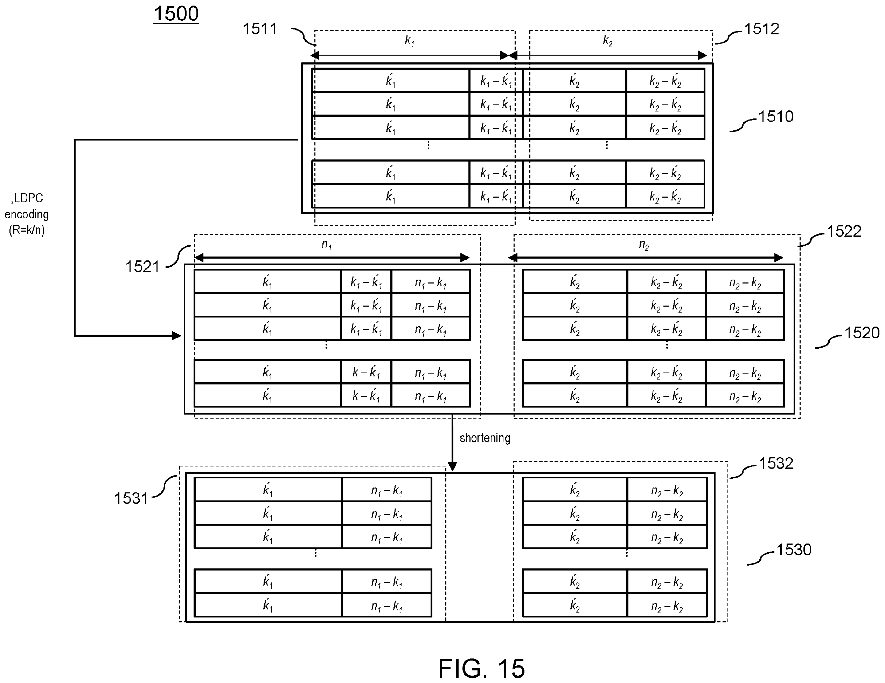

FIG. 15 is a diagram 1500 depicting an example process of encoding data with two code rates based on different code block lengths using different LDPC encoders, according to one or more embodiments. A system can encode a plurality of types of data (or plurality of data streams) with a plurality of code block lengths (e.g., $n_1$, $n_2$, ...) using a plurality of native code rates provided by a plurality of LDPC encoders (or a plurality of LDPC codes). Referring to FIG. 15, in process step 1510, a system can split or divide input data into data stream 1 (1511) and data stream 2 (1512) at the MAC layer or the PHY layer. The system can determine native code rates $R_1$ (=$k_1/n_1$) and $R_2$ (=$k_2/n_2$) for the data stream 1 and the data stream 2, respectively, based on conditions of RUs (e.g., SNR gap/difference between the RUs). The system can determine coding parameters to encode the data stream 1 and the data stream 2 (e.g., $\acute{k}_1$, $\acute{k}_2$) based on conditions of RUs. The system can (1) divide the data stream 1 into a plurality of information blocks each with a size $\acute{k}_1$, (2) divide the data stream 2 into a plurality of information blocks each with a size $\acute{k}_2$, (3) add a plurality of first padded data or frozen blocks (e.g., using a pre-FEC pad 1004-1) each with a size $(k_1 - \acute{k}_1)$ to increase the size of each information block to $k_1$, and/or (4) add a plurality of second padded data or frozen blocks (e.g., using a pre-FEC pad 1004-2) each with a size

$(k_2 - k_2')$ to increase the size of each information block to $k_2$.

In process step 1520, the system can perform LDPC encoding on the data stream 1 using an LDPC code with a native code rate $R_1$ (=$k_1/n_1$) to generate a first codeword 1521 with size $n_1$. The system can also perform LDPC encoding on the data stream 2 using an LDPC code with a native code rate $R_2$ (=$k_2/n_2$) to generate a second codeword 1522 with size $n_2$. The system can execute or run two LDPC encoders (with code rates $R_1$ and $R_2$ respectively) on the data stream 1 and the data stream 2 in a time multiplexed manner. In some implementations, the system can execute or run two LDPC encoders (with code rates $R_1$ and $R_2$ respectively) on the data stream 1 and the data stream 2 in parallel. In process step 1530, the system can perform shortening by (1) removing or discarding the plurality of first frozen blocks (e.g., each first frozen block with size $(k_1 - k_1')$) the from the first codeword to generate first encoded data 1531 (with the code rate $R_1$) corresponding to the data stream 1, and/or (2) removing or discarding the plurality of second frozen blocks (e.g., each second frozen block with the size $(k_2 - k_2')$) from the second codeword to generate second encoded data 1532 (with the code rate $R_2$) corresponding to the data stream 2. Upon discarding the first and second frozen blocks, the system can provide or send the first encoded data 1531 and the second encoded data 1532 to QAM (e.g., QAM with different values of M).

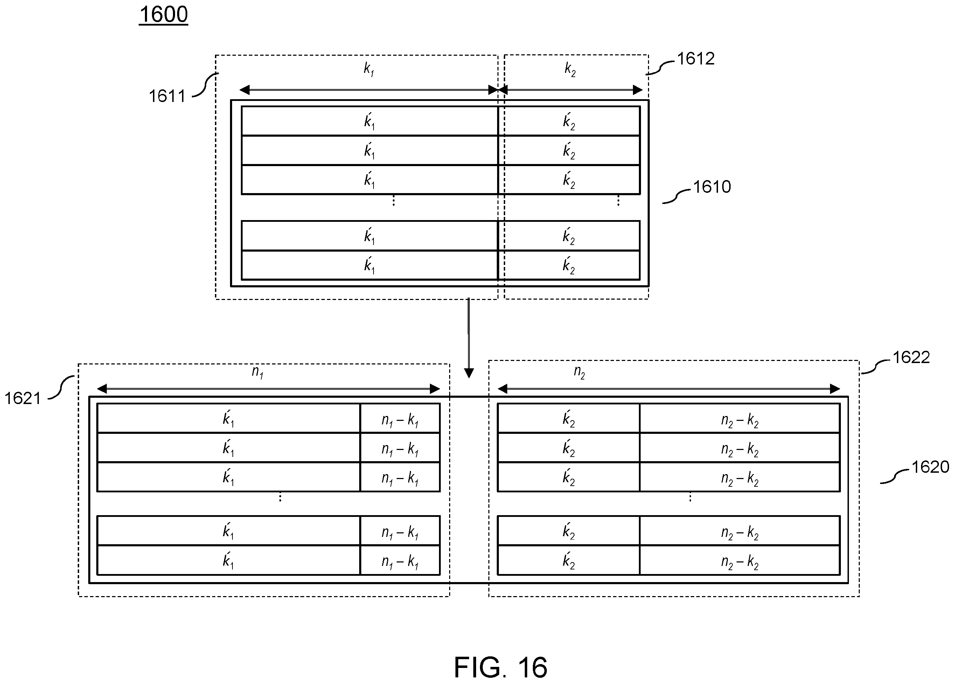

FIG. 16 is a diagram 1600 depicting another example process of encoding data with two code rates based on different code block lengths using different LDPC encoders, according to one or more embodiments. A system can encode a plurality of types of data (or plurality of data streams) with a plurality of code block lengths (e.g., $n_1$, $n_2$, ...) using a plurality of native code rates provided by a plurality of LDPC encoders (or a plurality of LDPC codes). Referring to FIG. 16, in process step 1610, a system can split or divide input data into data stream 1 (1611) and data stream 2 (1612) at the MAC layer or the PHY layer. The system can determine native code rates $R_1$ (=$k_1/n_1$) and $R_2$ (=$k_2/n_2$) for the data stream 1 and the data stream 2, respectively, based on conditions of RUs (e.g., SNR gap/difference between the RUs). The system can (1) divide the data stream 1 into a plurality of information blocks each with a size $k_1$, and (2) divide the data stream 2 into a plurality of information blocks each with a size $k_2$. In process step 1620, the system can perform LDPC encoding on the data stream 1 using an LDPC code with a native code rate $R_1$ (=$k_1/n_1$) to generate a first codeword with size $n_1$ (as first encoded data 1621). The system can also perform LDPC encoding on the data stream 2 using an LDPC code with a native code rate $R_2$ (=$k_2/n_2$) to generate a second codeword with size $n_2$ (as second encoded data 1622). The system can execute or run two LDPC encoders (with code rates $R_1$ and $R_2$ respectively) on the data stream 1 and the data stream 2 in a time multiplexed manner. In some implementations, the system can execute or run two LDPC encoders (with code rates $R_1$ and $R_2$ respectively) on the data stream 1 and the data stream 2 in parallel. Upon completion of the encoding of the data stream 1 and the data stream 2, the system can provide or send the first encoded data 1621 and the second encoded data 1622 to QAM (e.g., QAM with different values of M).

In some implementations, an apparatus (e.g., communication system 105) may include a transmitter (e.g., transmitter circuitry 120) and one or more processors (e.g., processor 2010). The one or more processors may identify a plurality of RUs (e.g., RU1 811, ..., RU9 819 in FIG. 8; $RU_1$, ..., $RU_m$ in FIG. 10) used for transmitting respective data streams within one or more wireless channels (e.g., a 20 MHz channel). A wireless channel refers to a frequency range within which wireless devices can communicate, one or more frequency bands used by wireless networks, or one or more specific frequencies in the electromagnetic spectrum, or any pathway or frequency range through which wireless signals travel to facilitate communication between devices.

In some implementations, the one or more processors may be configured to receive a data stream. The one or more processors may be configured to determine, by a medium access control (MAC) layer, (1) different traffic types of the data stream (e.g., type-1 data, type-2 data in FIG. 13A), (2) different levels of priority of the data stream or (3) different levels of quality of service (QoS) of the data stream. The one or more processors may be configured to split, by the MAC layer, the data stream into the respective data streams (e.g., type-1 data, type-2 data in FIG. 13A) based at least on the different data types, the different levels of priority or the different levels of QoS.

In some implementations, the one or more processors may determine, based at least on a difference in signal quality between transmissions across the plurality of RUs (e.g., SNR gap or EVM gap between RUs), respective numbers of bits (e.g., numbers of bits per symbol corresponding to values of M=16, 32, 64, ..., 4096) for the plurality of RUs. In some implementations, the difference in signal quality between the plurality of RUs may be a difference in signal-to-noise ratio (SNR) between the transmissions across the plurality of RUs (e.g., SNR gap or EVM gap).

The respective numbers of bits may be different from each other. The one or more processors may modulate, using the respective numbers of bits, the respective data streams (e.g., perform QAM using different values of M=16, 32, 64, ..., 4096) to generate respective modulated data streams. The transmitter may transmit the respective modulated data streams using respective RUs. In some implementations, in modulating the respective data streams, the one or more processors may be configured to perform, for each RU, a quadrature amplitude modulation (QAM) using the respective number of bits as a number of bits per symbol (e.g., a number of bits per symbol corresponding to a value of M=16, 32, 64, ..., 4096).

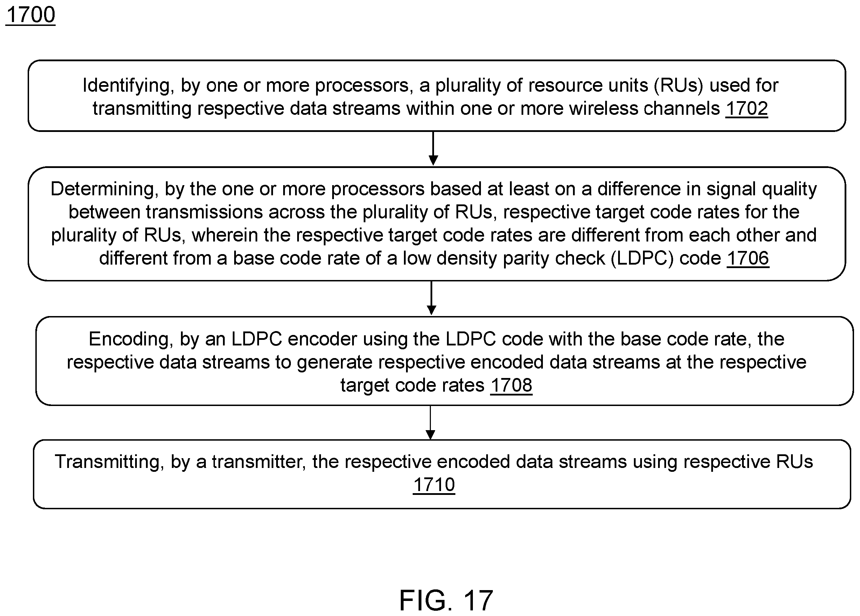

FIG. 17 is a flow diagram showing a process 1700 for providing multiple code rates across different RUs, in accordance with an embodiment. In some implementations, the process 1700 is performed by one or more processors of a device (e.g. processor 2010 of communication system 105). In other embodiments, the process 1700 is performed by other entities (e.g., a computing system other than the communication system 105). In some implementations, the process 1700 includes more, fewer, or different steps than shown in FIG. 17.

At step 1702, the one or more processors may identify a plurality of RUs (e.g., $RU_1$ and $RU_2$ in FIG. 9; $RU_1$, $RU_2$, ..., $RU_m$ in FIG. 9) used for transmitting respective data streams within one or more wireless channels (e.g., a 20MHz channel).

In some implementations, the one or more processors may receive a data stream (e.g., a single data stream). A medium access control (MAC) layer may determine (1) different traffic types of the data stream (e.g., video, text, audio, etc.), (2) different levels of priority of the data stream or (3) different levels of quality of service (QoS) of the data stream. Based at least on the different data types, the different levels of priority or the different levels of QoS, the MAC layer may split the data stream into the respective data streams (e.g., type-1 data 1611, type-2 data 1612).

In some implementations, respective sizes of information bits for the plurality of RUs may be selected based at least on the respective target code rates and the base code rate. For example, respective sizes of information bits (e.g., $\acute{k}_\iota$, $\acute{k}_2$ in FIG. 11A) may be selected based at least on the respective target code rates (e.g., $R_1$, $R_2$ in FIG. 11A) and the base code rate (e.g., R in FIG. 11A). Based at least on the respective sizes of information bits (e.g., $\acute{k}_\iota$, $\acute{k}_2$ in FIG. 13B), a physical (PHY) layer may split a data stream into the respective data streams (e.g., data stream 1, data stream 2 in FIG. 13B). The PHY layer may add respective data (e.g., ($\acute{k}_1 - \Delta_1$) 1351 in FIG. 13B) to the respective data streams (e.g., data stream 1 in FIG. 13B) according to the selected respective sizes of information bits (e.g., $\acute{k}_\iota$ in FIG. 13B).

At step 1704, the one or more processors may determine, based at least on a difference in signal quality between transmissions across the plurality of RUs (e.g., SNR gap or EVM gap), respective target code rates (e.g., $R_1$, $R_2$) for the plurality of RUs. For example, a system having a first SNR gap (between a stronger RU and a weaker RU) that is greater than a second SNR gap can select a code rate (for the stronger RU) higher than a code rate selected by a system having the second SNR gap. In some implementations, the difference in signal quality between the plurality of RUs may be a difference in signal-to-noise ratio (SNR) between the transmissions across the plurality of RUs. The respective target code rates (e.g., $R_1$=3/4, $R_2$=2/3 in FIG. 11B) may be different from each other and different from a base code rate of a low density parity check (LDPC) code (e.g., R=5/6 in FIG. 11B).

In some implementations, the information rate of an RU with QAM size M and code rate R is $\log_2(M)*R$ (unit is bits/second/Hz). On every 1 bit change in information rate may approximately need to budget 3dB of SNR. Therefore, given an SNR gap $\Delta S$ and QAM sizes M1 and M2 (of a stronger RU1 and a weaker RU2, respectively), a target code rate $R_1$ (of the RU1) and a target code rate $R_2$ (of the RU2) can be found using the following equation:

$$3(Info\_rate_1 - Info\_rate_2) = 3((\log_2 M_1) * R_1 - (\log_2 M_2) * R_2) = \Delta S \ldots\ldots\ldots\ldots \text{(Equation 17)}$$

where $Info\_rate_1$ and $Info\_rate_2$ are the information rate of the RU1 and the information rate of the RU2, respectively. In other words, finding $R_1$ and $R_2$ given an SNR gap can be a two-dimensional search using Equation 17.

At step 1706, the one or more processors may encode, by an LDPC encoder using the LDPC code with the base code rate, the respective data streams to generate respective encoded data streams at the respective target code rates. In some implementations, in encoding the respective data streams, a base size of information bits corresponding to the base code rate (e.g., k=1296, R=2/3 in Table 1) may be determined. A second set of information bits (e.g., information bits with size ($\acute{k}_1 + \theta$) in data block 1431) may generated from each respective data stream, to include a first set of information bits (e.g., information bits with size $\acute{k}_1$ in data block 1421) corresponding to the selected respective size of information bits and one or more bits (e.g., $\theta = (k - \acute{k}_\iota)$) to increase a size of the second set of information to correspond to the base size of information bits (e.g., k in data block 1431). The LDPC encoder may encode, using the base code rate, the second set of information bits (e.g., information bits with size ($\acute{k}_1 + \theta$) in data block 1431) to generate parity data (e.g., (n-k) in data block 1441). The respective encoded data stream may be generated by concatenating the second set of information bits (e.g., information bits with size ($\acute{k}_1 + \theta$) in data block 1441) and the parity data (e.g., (n-k) in data block 1441).

In some implementations, in encoding the respective data streams, the respective data streams may be encoded serially or in parallel. In some implementations, the respective encoded data streams may be multiplexed to perform a stream-wise modulation. For example, referring to FIG. 14, the type-1 data and the type-2 data can be serially encoded using a common, single LDPC encoder that can provide multiple code rates based on a single mother code rate. The system can execute or run a (single) LDPC encoder on the type-1 data and the type-2 data in a time multiplexed manner. The system can execute or run two LDPC encoders (with the same mother code) on the type-1 data and the type-2 data in parallel.

At step 1708, the transmitter (e.g., transmitter circuitry 120) may transmit the respective encoded data streams (e.g., first encoded data 1451, second encoded data 1452) using respective RUs.

References to "or" may be construed as inclusive so that any terms described using "or" may indicate any of a single, more than one, and all of the described terms. References to at least one of a conjunctive list of terms may be construed as an inclusive OR to indicate any of a single, more than one, and all of the described terms. For example, a reference to "at least one of 'A' and 'B'" can include only 'A', only 'B', as well as both 'A' and 'B'. Such references used in conjunction with "comprising" or other open terminology can include additional items.

It should be noted that certain passages of this disclosure can reference terms such as "first" and "second" in connection with subsets of transmit spatial streams, sounding frames, response, and devices, for purposes of identifying or differentiating one from another or from others. These terms are not intended to merely relate entities (e.g., a first device and a second device) temporally or according to a sequence, although in some cases, these entities can include such a relationship. Nor do these terms limit the number of possible entities (e.g., STAs, APs, beamformers and/or beamformees) that can operate within a system or environment. It should be understood that the systems described above can provide multiple ones of any or each of those components and these components can be provided on either a standalone machine or, In some implementations, on multiple machines in a distributed system. Further still, bit field positions can be changed and multibit words can be used. In addition, the systems and methods described above can be provided as one or more computer-readable programs or executable instructions embodied on or in one or more articles of manufacture, e.g., a floppy disk, a hard disk, a CD-ROM, a flash memory card, a PROM, a RAM, a ROM, or a magnetic tape. The programs can be implemented in any programming language, such as LISP, PERL, C, C++, C#, or in any byte code language such as JAVA. The software programs or executable instructions can be stored on or in one or more articles of manufacture as object code.

While the foregoing written description of the methods and systems enables one of ordinary skill to make and use embodiments thereof, those of ordinary skill will understand and appreciate the existence of variations, combinations, and equivalents of the specific embodiment, method, and examples herein. The present methods and systems should therefore not be limited by the above described embodiments, methods, and examples, but by all embodiments and methods within the scope and spirit of the disclosure.

## Claims

1. An apparatus comprising:

    a transmitter (120) and one or more processors (2010), wherein
    the one or more processors (2010) are configured to:

        identify a plurality of resource units,Rus, (1022) used for transmitting respective data streams within one or more wireless channels;
        determine, based at least on a difference in signal quality between transmissions across the plurality of RUs (1022), respective target code rates for the plurality of RUs (1022), wherein the respective target code rates are different from each other and different from a base code rate of a low density parity check, LDPC, code; and
        encode, by an LDPC encoder (1006) using the LDPC code with the base code rate, the respective data streams to generate respective encoded data streams at the respective target code rates; and

    wherein the transmitter (120) is configured to transmit the respective encoded data streams using the plurality of respective RUs (1022).

2. The apparatus of claim 1, wherein the difference in signal quality between the plurality of RUs (1022) is a difference in signal-to-noise ratio, SNR, between the transmissions across the plurality of RUs (1022).

3. The apparatus of claim 1 or 2, wherein the one or more processors (2010) are further configured to:

    receive a data stream;

determine, by a medium access control, MAC, layer, (1) different traffic types of the data stream, (2) different levels of priority of the data stream or (3) different levels of quality of service, QoS, of the data stream; based at least on the different data types, the different levels of priority or the different levels of QoS, split, by the MAC layer, the data stream into the respective data streams.

4. The apparatus of any of claims 1 to 3, wherein the one or more processors (2010) are further configured to:

select, based at least on the respective target code rates and the base code rate, respective sizes of information bits for the plurality of RUs (1022);
in particular wherein the one or more processors (2010) are configured to:

based at least on the respective sizes of information bits, split, by a physical, PHY, layer, a data stream into the respective data streams; and
add, by the PHY layer, respective data to the respective data streams according to the selected respective sizes of information bits.

5. The apparatus of claim 4, wherein in encoding the respective data streams, the one or more processors (2010) are further configured to:

determine a base size of information bits corresponding to the base code rate;
generate, from each respective data stream, a second set of information bits to include a first set of information bits corresponding to the selected respective size of information bits and one or more bits to increase a size of the second set of information to correspond to the base size of information bits;
encode, by the LDPC encoder (1006) using the base code rate, the second set of information bits to generate parity data; and
generate the respective encoded data stream by concatenating the second set of information bits and the parity data.

6. The apparatus of any of claims 1 to 5, comprising at least one of the following features:

(i) wherein the one or more processors (2010) are further configured to encode the respective data streams serially or in parallel;
(ii) wherein the one or more processors (2010) are further configured to multiplex the respective encoded data streams to perform a stream-wise modulation.

7. A method comprising:

identifying, by one or more processors (2010), a plurality of resource units, RUs, (1022 used for transmitting respective data streams within one or more wireless channels;
determining, by the one or more processors (2010) based at least on a difference in signal quality between transmissions across the plurality of RUs (1022), respective target code rates for the plurality of RUs (1022), wherein the respective target code rates are different from each other and different from a base code rate of a low density parity check, LDPC, code;
encoding, by an LDPC encoder (1006) using the LDPC code with the base code rate, the respective data streams to generate respective encoded data streams at the respective target code rates; and
transmitting, by a transmitter (120), the respective encoded data streams using respective RUs (1022).

8. The method of claim 7, wherein the difference in signal quality between the plurality of RUs (1022) is a difference in signal-to-noise ratio, SNR, between the transmissions across the plurality of RUs (1022).

9. The method of claim 7 or 8, further comprising:

receiving a data stream;
determining, by a medium access control, MAC, layer, (1) different traffic types of the data stream, (2) different levels of priority of the data stream or (3) different levels of quality of service, QoS, of the data stream;
based at least on the different data types, the different levels of priority or the different levels of QoS, splitting, by the MAC layer, the data stream into the respective data streams.

**10.** The method of any of claims 7 to 9, further comprising:
selecting, based at least on the respective target code rates and the base code rate, respective sizes of information bits for the plurality of RUs (1022).

**11.** The method of claim 10, further comprising:

based at least on the respective sizes of information bits, splitting, by a physical, PHY, layer, a data stream into the respective data streams; and
adding, by the PHY layer, respective data to the respective data streams according to the selected respective sizes of information bits.

**12.** The method of claim 10 or 11, wherein encoding the respective data streams comprises:

determining a base size of information bits corresponding to the base code rate;
generating, from each respective data stream, a second set of information bits to include a first set of information bits corresponding to the selected respective size of information bits and one or more bits to increase a size of the second set of information to correspond to the base size of information bits;
encoding, by the LDPC encoder (1006) using the base code rate, the second set of information bits to generate parity data; and
generating the respective encoded data stream by concatenating the second set of information bits and the parity data.

**13.** The method of any of claims 7 to 12, comprising at least one of the following features:

(i) wherein encoding the respective data streams comprises:
encoding the respective data streams serially or in parallel;
(ii) further comprising:
multiplexing the respective encoded data streams to perform a stream-wise modulation.

**14.** An apparatus comprising:

a transmitter (120) and one or more processors (2010), wherein
the one or more processors (2010) are configured to:

identify a plurality of resource units, Rus, (1022) used for transmitting respective data streams within one or more wireless channels;
determine, based at least on a difference in signal quality between transmissions across the plurality of RUs (1022), respective numbers of bits for the plurality of RUs (1022), wherein the respective numbers of bits are different from each other; and
modulate, using the respective numbers of bits, the respective data streams to generate respective modulated data streams,

wherein the transmitter (120) is configured to transmit the respective modulated data streams using respective RUs (1022).

**15.** The apparatus of claim 14, comprising at least one of the following features:

(i) wherein the difference in signal quality between the plurality of RUs (1022) is a difference in signal-to-noise ratio, SNR, between the transmissions across the plurality of RUs (1022);
(ii) wherein in modulating the respective data streams, the one or more processors (2010) are configured to perform, for each RU (1022), a quadrature amplitude modulation, QAM, using the respective number of bits as a number of bits per symbol;
(iii) wherein the one or more processors (2010) are configured to:

receive a data stream;
determine, by a medium access control, MAC, layer, (1) different traffic types of the data stream, (2) different levels of priority of the data stream or (3) different levels of quality of service, QoS, of the data stream;
based at least on the different data types, the different levels of priority or the different levels of QoS, split, by the MAC layer, the data stream into the respective data streams.

100

105

Baseband Circuitry 110

Encoder 130

115

Transmitter Circuitry 120

125

108

Receiver Circuitry 140

145

Baseband Circuitry 150

Decoder 160

EP 4 654 503 A1

FIG. 1

**Computing system 2000**

Cache
2020

Processor
2010

I/O Components
2050

Display
2070

Input Device
2080

Communication System 2040

Memory
2060

Network Interface
Device 2030

EP 4 654 503 A1

FIG. 2

300

$24R$   $24(1-R)-1$

312

| | | |
| --- | --- | --- |
| $A$ **310** | $B$ | $T$ **314** |
| $C$ **316** | $D$ | $E$ **320** |

318

FIG. 3

400

EP 4 654 503 A1

7x7 SparseMatrixCSC{Int64, Int64} with 0 stored entries:

d=-1
```
· · · · · · ·
· · · · · · ·
· · · · · · ·          409
· · · · · · ·
· · · · · · ·
· · · · · · ·
· · · · · · ·
```

7x7 SparseMatrixCSC{Bool, Int64} with 7 stored entries:

d=0
```
1 · · · · · ·
· 1 · · · · ·
· · 1 · · · ·          410
· · · 1 · · ·
· · · · 1 · ·
· · · · · 1 ·
· · · · · · 1
```

7x7 SparseMatrixCSC{Bool, Int64} with 7 stored entries:

d=1
```
· 1 · · · · ·
· · 1 · · · ·
· · · 1 · · ·          411
· · · · 1 · ·
· · · · · 1 ·
· · · · · · 1
1 · · · · · ·
```

7x7 SparseMatrixCSC{Bool, Int64} with 7 stored entries:

d=2
```
· · 1 · · · ·
· · · 1 · · ·
· · · · 1 · ·          412
· · · · · 1 ·
· · · · · · 1
1 · · · · · ·
· 1 · · · · ·
```

7x7 SparseMatrixCSC{Bool, Int64} with 7 stored entries:

d=3
```
· · · 1 · · ·
· · · · 1 · ·
· · · · · 1 ·          413
· · · · · · 1
1 · · · · · ·
· 1 · · · · ·
· · 1 · · · ·
```

7x7 SparseMatrixCSC{Bool, Int64} with 7 stored entries:

d=4
```
· · · · 1 · ·
· · · · · 1 ·
· · · · · · 1          414
1 · · · · · ·
· 1 · · · · ·
· · 1 · · · ·
· · · 1 · · ·
```

7x7 SparseMatrixCSC{Bool, Int64} with 7 stored entries:

d=5
```
· · · · · 1 ·
· · · · · · 1
1 · · · · · ·          415
· 1 · · · · ·
· · 1 · · · ·
· · · 1 · · ·
· · · · 1 · ·
```

7x7 SparseMatrixCSC{Bool, Int64} with 7 stored entries:

d=6
```
· · · · · · 1
1 · · · · · ·
· 1 · · · · ·          416
· · 1 · · · ·
· · · 1 · · ·
· · · · 1 · ·
· · · · · 1 ·
```

FIG. 4

$n-m$ | $g$ | $m-g$    515

A
510

B
512

$m-g$

F 514

$m$

C
516

D
518

E
520

$g$

$n$

FIG. 5

EP 4 654 503 A1

600

_A_ 610

_B_ 612

_C_ 616

_T_ 614

_D_ 618

_E_ 620

FIG. 6

## 700

FIG. 7

800

| 810 26-RUs | 26-RU1 811 | 26-RU2 812 | 26-RU3 813 | 26-RU4 814 | 26-RU5 815 | 26-RU6 816 | 26-RU7 817 | 26-RU8 818 | 26-RU9 819 |

| 820 52-RUs | 52-RU1 821 | 52-RU2 822 | | 52-RU3 823 | 52-RU4 824 |

| 830 106-RUs | 106-RU1 831 | | 106-RU2 832 |

FIG. 8

EP 4 654 503 A1

801

801

| $QAM_1$, LDPC, $R_1$ | $QAM_2$, LDPC, $R_2$ |
|---|---|

$RU_1$　　　　　　　　　　　　　　$RU_2$

FIG. 9

FIG. 10

1000

Scrambler 1002-1 → Pre-FEC pad 1004-1 → LDPC Encoder 1006-1 → Post-FEC pad 1008-1

Scrambler 1002-m → Pre-FEC pad 1004-m → LDPC Encoder 1006-m → Post-FEC pad 1008-m

QAM 1020-1 → $RU_1$ 1022-1 → IDFT 1040-1 → CP 1042-1 → Wn 1050-1 → AFE 1052-1

QAM 1020-m → $RU_m$ 1022-m → IDFT 1040-m → CP 1042-m → Wn 1050-m → AFE 1052-m

FIG. 11B

FIG. 11A

**1200**

1204-1

$R_1$

1204-$m$

$R_m$

$R = k/n$
**1202**

1206-1 1208-1

$\acute{k}_1, \acute{n}_1$

$\acute{k}_m, \acute{n}_m$

1206-$m$ 1208-$m$

**FIG. 12A**

**1250**

$R_1 = 3/4$

$R_m = 2/3$

$R = 5/6$
**1252**

$\acute{K}_1 = 972,$
$\acute{n}_1 = 1296$

$\acute{K}_2 = 648,$
$\acute{n}_2 = 972$

$n = 1944$

**FIG. 12B**

EP 4 654 503 A1

FIG. 13A

FIG. 13B

EP 4 654 503 A1

FIG. 13C

EP 4 654 503 A1

FIG. 14

EP 4 654 503 A1

1500

1511     1512

$k_1$    $k_2$

1510

| $k_1'$ | $k_1 - k_1'$ | $k_2'$ | $k_2 - k_2'$ |
| $k_1'$ | $k_1 - k_1'$ | $k_2'$ | $k_2 - k_2'$ |
| $k_1'$ | $k_1 - k_1'$ | $k_2'$ | $k_2 - k_2'$ |
| $k_1'$ | $k_1 - k_1'$ | $k_2'$ | $k_2 - k_2'$ |
| $k_1'$ | $k_1 - k_1'$ | $k_2'$ | $k_2 - k_2'$ |

LDPC encoding (R=k/n)

1521    1522

$n_1$    $n_2$

1520

| $k_1'$ | $k_1 - k_1'$ | $n_1 - k_1$ | $k_2'$ | $k_2 - k_2'$ | $n_2 - k_2$ |
| $k_1'$ | $k_1 - k_1'$ | $n_1 - k_1$ | $k_2'$ | $k_2 - k_2'$ | $n_2 - k_2$ |
| $k_1'$ | $k_1 - k_1'$ | $n_1 - k_1$ | $k_2'$ | $k_2 - k_2'$ | $n_2 - k_2$ |
| $k_1'$ | $k - k_1'$ | $n_1 - k_1$ | $k_2'$ | $k_2 - k_2'$ | $n_2 - k_2$ |
| $k_1'$ | $k - k_1'$ | $n_1 - k_1$ | $k_2'$ | $k_2 - k_2'$ | $n_2 - k_2$ |

shortening

1531    1532

1530

| $k_1'$ | $n_1 - k_1$ | $k_2'$ | $n_2 - k_2$ |
| $k_1'$ | $n_1 - k_1$ | $k_2'$ | $n_2 - k_2$ |
| $k_1'$ | $n_1 - k_1$ | $k_2'$ | $n_2 - k_2$ |
| $k_1'$ | $n_1 - k_1$ | $k_2'$ | $n_2 - k_2$ |
| $k_1'$ | $n_1 - k_1$ | $k_2'$ | $n_2 - k_2$ |

FIG. 15

FIG. 16

EP 4 654 503 A1

<u>1700</u>

Identifying, by one or more processors, a plurality of resource units (RUs) used for transmitting respective data streams within one or more wireless channels <u>1702</u>

Determining, by the one or more processors based at least on a difference in signal quality between transmissions across the plurality of RUs, respective target code rates for the plurality of RUs, wherein the respective target code rates are different from each other and different from a base code rate of a low density parity check (LDPC) code <u>1706</u>

Encoding, by an LDPC encoder using the LDPC code with the base code rate, the respective data streams to generate respective encoded data streams at the respective target code rates <u>1708</u>

Transmitting, by a transmitter, the respective encoded data streams using respective RUs <u>1710</u>

FIG. 17

EP 4 654 503 A1

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2024/031053 A1 (PEDERSEN KLAUS INGEMANN [DK] ET AL) 25 January 2024 (2024-01-25) * paragraphs [0111] - [0117] * | 1-15 | INV. H04L1/00 H04L5/00 |
| X | US 2024/048265 A1 (SONG HAO [US] ET AL) 8 February 2024 (2024-02-08) * paragraphs [0098] - [0100], [0178] * | 1-15 | |
| X | US 2021/288752 A1 (SUH JUNG HOON [CA] ET AL) 16 September 2021 (2021-09-16) * paragraphs [0020], [0060], [0078], [0082], [0083] * | 1-15 | |
| X | US 10 985 862 B2 (MEDIATEK INC [TW]) 20 April 2021 (2021-04-20) * columns 4,5; claim 1 * | 1-15 | |
| A | ZTE: "Structured LDPC coding with rate matching", 3GPP DRAFT; R1-061019 STRUCTURED LDPC CODING WITH RATE MATCHING, 3RD GENERATION PARTNERSHIP PROJECT (3GPP), MOBILE COMPETENCE CENTRE ; 650, ROUTE DES LUCIOLES ; F-06921 SOPHIA-ANTIPOLIS CEDEX ; FRANCE, vol. RAN WG1, no. Athens, Greece; 20060321, 21 March 2006 (2006-03-21), XP050101917, [retrieved on 2006-03-21] * Section 3 * | 1-15 | **TECHNICAL FIELDS SEARCHED (IPC)** H04L |

The present search report has been drawn up for all claims

| Place of search | Date of completion of the search | Examiner |
|---|---|---|
| Munich | 9 October 2025 | Flores Sanchez, L |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 17 7909

09-10-2025

| Patent document cited in search report | Publication date | Patent family member(s) | Publication date |
|---|---|---|---|
| US 2024031053 A1 | 25-01-2024 | EP 4312392 A1 | 31-01-2024 |
| | | US 2024031053 A1 | 25-01-2024 |
| US 2024048265 A1 | 08-02-2024 | EP 4518207 A1 | 05-03-2025 |
| | | KR 20250032928 A | 07-03-2025 |
| | | US 2024048265 A1 | 08-02-2024 |
| US 2021288752 A1 | 16-09-2021 | CN 115280694 A | 01-11-2022 |
| | | CN 118282577 A | 02-07-2024 |
| | | EP 4111613 A1 | 04-01-2023 |
| | | JP 7540843 B2 | 27-08-2024 |
| | | JP 2023518183 A | 28-04-2023 |
| | | KR 20220152278 A | 15-11-2022 |
| | | US 2021288752 A1 | 16-09-2021 |
| | | WO 2021180236 A1 | 16-09-2021 |
| US 10985862 B2 | 20-04-2021 | EP 3291473 A1 | 07-03-2018 |
| | | US 2018062787 A1 | 01-03-2018 |

**REFERENCES CITED IN THE DESCRIPTION**

**Patent documents cited in the description**

- US 63651710